# EUROPEAN PATENT SPECIFICATION

(11) **EP 3 297 132 B1**
(45) Date of publication and mention of the grant of the patent: **13.05.2020**
(21) Application number: 16189585.9
(22) Date of filing: 20.09.2016
(51) Int. Cl.: H02K 3/26, H02K 3/04, H02K 3/47, H05K 1/02, H05K 1/16

(54) **WINDING STRUCTURE FOR ELECTRICAL MACHINE AND METHOD FOR DESIGNING A WINDING STRUCTURE**
WICKLUNGSSTRUKTUR FÜR ELEKTRISCHE MASCHINE UND VERFAHREN ZUM ENTWURF SOLCH EINER WICKLUNGSSTRUKTUR
STRUCTURE D'ENROULEMENT POUR MACHINE ÉLECTRIQUE ET PROCÉDÉ DE CONCEPTION D'UNE STRUCTURE D'ENROULEMENT

(43) Date of publication of application: 21.03.2018
(73) Proprietor: Celeroton AG, 8604 Volketswil (CH)
(72) Inventor: Looser, Andreas, 8051 Zürich (CH)
(74) Representative: Frei Patent Attorneys

(56) References cited:
- WO-A2-2004/073365
- GB-A- 2 233 157
- US-A1- 2002 171 306
- DEHEZ BRUNO ET AL: "Analysis of a new topology of flexible PCB winding for slotless BLDC machines", 2014 INTERNATIONAL CONFERENCE ON ELECTRICAL MACHINES (ICEM), IEEE, 2 September 2014 (2014-09-02), pages 1963-1969, XP032687802, DOI: 10.1109/ICELMACH.2014.6960453 [retrieved on 2014-11-17]

## Description

The invention relates to coils for use in an electrical machine, such as an electric motor or an electric generator, and in particular to a **winding structure for an electrical machine and a method for designing a winding structure,** e.g. for use as an airgap winding in a slotless electrical machine.

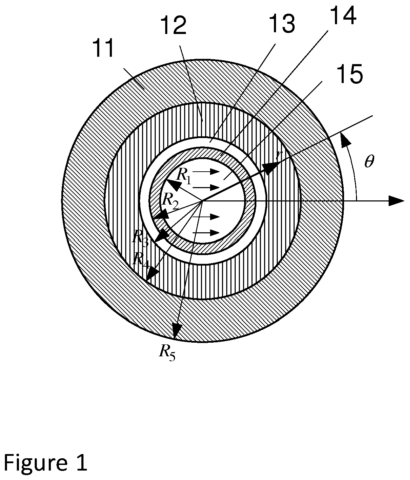

High-speed synchronous machines with permanent magnets are preferably constructed with an air gap winding (see Figure 1). The main reason for this is to avoid harmonic losses. In lower speed machines often a single, thick conductor is used. For high-speed machines the conductor is exposed to the rapidly alternating magnetic field of the rotor, and the usage of a single, thick conductor would cause eddy current losses in the conductor.

Therefore high-speed machines typically utilize litz wires consisting of a plurality of fine wire strands, which are electrically insulated from each other (see US7402934B1, US2013300241A1). In order to minimize circulating currents in the phase winding, which occur due to different voltages being induced in the individual wires, the litz wires usually are twisted. The higher the number of twists per length unit is, the smaller are the losses caused by circulating currents.

Different types of air-gap windings are known: straight line windings (with winding support), rhombus windings (cantilever, also called 'Maxon-winding', see EP1780871A1) and skew windings (cantilever, also called 'Faulhaber-winding').

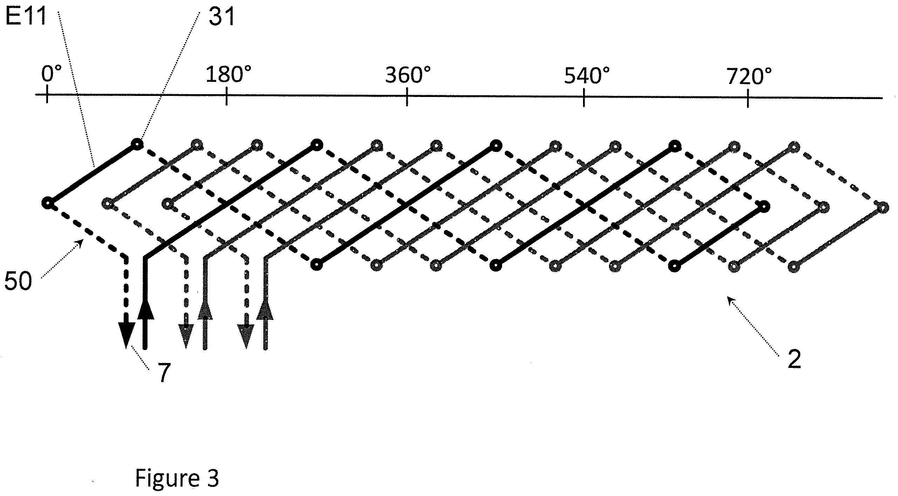

Because of its structure the skew winding is particularly suitable for the implementation as a flexible printed circuit or flexprint. *"*Theoretical and Experimental Investigation of flex-PCB Airgap Windings in Slotless BLDC Machines", by DEHEZ, B.; BAUDART, F.; MARKOVIC, M.; PERRIARD, Y., IEEE Transactions on Industry Applications, 2014*, see e.g.* *Fig. 3**,* describes a winding assembled on a two-layer flexible printed circuit, where the conductor for a 2-pole machine covers 180° (coiled flex print) on one layer and is then connected in series to a conductor of the other layer by a via.

In the paper *"*Analysis of a new topology of flexible PCB winding for slotless BLDC machines", by DEHEZ, B.; BAUDART, F.; 2014 International conference on electrical machines (ICEM), IEEE, 2 September 2014, pages 1963-1969*,* the authors compare three topologies of overlapping distributed windings on flexible PCBs. Each disclosed winding is being assembled on a two-layer flexible printed circuit and is comprised of adjacent loops connected in series. The first winding is a rhombic winding wherein each loop is composed of four straight segments. The loops of the second winding are each composed of four curve segments, which - as the paper explains - allows to better intercept the flux while reducing the phase resistance. In a third disclosed winding, forth and back tracks are connected via horizontal tracks giving the loops a spiral shape. As the paper explains, this topology allows for a reduction of length and resistance of the winding. For improving this effect, the paper proposes to further increase the extending of the horizontal tracks.

It is therefore an object of the invention to design an improved winding structure and method for designing a winding structure for an electrical machine.

A further object of the invention is to design a winding structure and method for designing a winding structure for an electrical machine which allows for a simple and cost effective production of the winding structure.

A further object of the invention is to design a winding structure and method for designing a winding structure for an electrical machine which allows an increased efficiency of the coil formed by the winding structure.

A further object of the invention is to design a winding structure and method for designing a winding structure for an electrical machine which leads to reduced or eliminated circulating currents when in operation in an electrical machine.

At least some of these objects are achieved at least in part by winding structures and methods for designing a winding structure according to the claims.

In the present context, high-speed machines are considered to be electrical machines designed for and operatable at speeds of, more than e.g. 50'000 RPM, 100'000 RPM or 200'000 RPM.

A **circuit structure** is a combination of conductors and an insulating substrate, where the conductors of the circuit are located in one or more, preferably two or more layers, which shall be called **layers of conductors.** Typically the layers are planar, which is to say thinner in one spatial dimension that in the other two spatial dimensions, e.g. less than 1/5^{th}, preferably less than 1/10^{th}, preferably less than 1/20^{th}, preferably less than 1/50^{th}, preferably less than 1/100^{th} of the minimum of the other two dimensions.
In an embodiment, it can be the case that the layers in the planer directions are 2-70mm long and in the direction orthogonal to the plane are 0.1-0.4 mm thin.
Usually two neighbouring layers of conductors are separated by an **insulating layer** to avoid shortcuts. Typically only the layers of conductors are mentioned and counted. For the remainder of the document the term **'layer'** shall typically denote a layer of conductors, unless otherwise implied by the context and **a circuit structure with *n* layers** shall denote a circuit structure with *n* layers of conductors, unless otherwise implied by the context. The layers of a circuit structure are typically parallel to each other. The axis orthogonal to one layer is therefore typically orthogonal to all layers, and therefore shall be deemed as orthogonal to the circuit structure.

A popular example of a circuit structure is a printed circuit board (PCB).

A circuit structure where the substrate is flexible shall be called a **flexible circuit structure.** Popular examples of a flexible circuit structures are flexible printed circuits (FPC) or flexible flat cables (FFC).

A flexible circuit structure realizing a winding structure shall be called a **flexible winding structure.**

In an embodiment of the invention, it can be the case that the elemental conductors are linear segments, piecewise linear segments, curved segments, s-shaped segments, bent lines or segments shaped in other ways.

In an embodiment, it can be the case that the elemental conductors are **parallel or substantially parallel.** Two segments are substantially parallel if their respective currents run in essentially the same direction. For substantially parallel conductors the induced magnetic fields are substantially parallel and superimpose to generate a stronger magnetic field. In this sense segments of different forms can be substantially parallel, e.g. a piecewise linear segment and a curved segment.

In an embodiment, it can be the case that the number of (conductive) layers is even.

In electrical machines a coil-element is one of the central elements used for creating magnetic fields varying over space and/or time. The varying magnetic fields allow for the transformation of electrical energy to kinetic energy or vice versa. The two most important types of movement for electric machines are the linear movement and the circular movement.

In an embodiment of the invention, it can be the case that a flexible winding structure is realized as a flexible circuit structure with two or more layers (of conductors) and forms a coil element.

A **current loop** of a winding structure is a, possibly virtual, loop that gives rise to a magnetic field. The loop can be virtual, which means it is not a sequence of directly galvanically connected segments forming a loop, but comprises segments connected in other manners, such that the currents in the boundary segments of the current loop are aligned to induce magnetic fields that superimpose inside the current loop. By the right hand rule the field lines are orthogonal to the current loop.

In an embodiment of a winding structure on a circuit structure, it can be the case that the magnetic field lines are orthogonal to the layer of the circuit structure.

In an embodiment, it can be the case that a **current loop is planar,** i.e. is its much thinner in one spatial dimension than in the other two spatial dimensions. The thin dimension of the current loop typically coincides with the thin dimension of the circuit structure, which is to say the current loops are substantially parallel to the layers and the almost linear magnetic field lines are orthogonal to the layers.

In an embodiment, it can be the case that at least one current loop for creating the magnetic field of the winding structure is planar, and the plane of the current loop is substantially parallel to the layers of the circuit structure and - seen from a perspective orthogonal to the layers - the planar current loop (macroscopically) bounds a topological disc.

Where a current loop - seen from a perspective orthogonal to the layers - bounds a topological disc, the current loop - seen from a perspective orthogonal to the layers - has the shape of a (topological) circle. This circle can comprise of one or more segments, which shall be called the boundary segments of a current loop.
A boundary segment of a current loop
- can be formed by one or more elemental conductors; or
- can be formed by segments of one or more elemental conductors.

In an embodiment, it can be the case that a current loop forms a (topological) circle and that the (topological) circle is a round circle, a rhombus/diamond (e.g. for a rhombus winding), a general polygon or another geometric form, e.g. wave-patterns (e.g. where s-shaped elemental conductors are used).

A **line of movement** is the line that a virtual point on a rotor of a rotational machine or on the runner of a linear machine draws on the stator side when moving under normal operation. The line of movement of a coil of an electrical machine is defined by the arrangement of current loops of the coil, which induce the varying magnetic fields and corresponding magnetic poles.

A **phase winding element** of a winding structure comprises electrically connected elements of the winding structure (in a graph theoretical sense, the phase winding element is a maximally connected circuit).

A **terminal for powering** (a circuit) is a point at which the circuit is designed to be connected to a conductor that is external to the circuit in the winding structure.
The terminals for powering denote the two end nodes of a winding phase element. A winding phase element can be connected to its terminals for powering in a star or delta configuration.

In an embodiment, it can be the case that the winding structure comprises at least one, preferably two or more winding phase elements.

A winding structure, where the substrate is flexible can be rolled to form a cylindrical winding structure.

In an embodiment, it can be the case that a flexible winding structure, which in its planar state corresponds to a linear line of movement, and the winding structure is rolled along the linear line of movement to form a cylindrical winding structure corresponding to a circular line of movement. By rolling, the linear line of movement is mapped to the circular line of movement.

For the remainder of the text it should be understood that, where appropriate, a described embodiment of a flexible (planar) winding structure can be rolled to form a cylindrical winding structure, and the terms which are used for describing the planar version translate to terms suitable for the cylindrical version by the transformation of rolling.

A flexible winding structure can be rolled one or multiple times. The rolling pattern can be indicated by the degrees a winding structure covers. E.g. where the pattern along the line of movement covers
- *360°,* the winding structure is rolled once;
- *720°,* the winding structure is rolled twice;
- *n*360°,* the winding structure is rolled *n* times;
- *540°,* the winding structure is rolled one and a half times;
- *180°+360°*n,* the winding structure is rolled *n* and a half times.

In an embodiment, it can be the case that the rolling pattern is arranged so that current loops, whose magnetic polarity matches, are located on top of each other after the rolling to create a current loop with higher winding number, so that their magnetic fields superimpose to generate a higher magnetic flux.

In an embodiment, it can be the case that the design is periodical with respect to a rolling pattern, e.g. segments of *180°* and/or *360°* along the line of movement are identical to one another.

### Winding loops and winding bundles

For the following embodiments, it can be the case that a flexible winding structure comprises at least one or a combination of the following features:
- being realized as a flexible circuit structure, the circuit structure comprising two or more layers (of conductors);
- one or more phase winding elements being formed of elemental conductors and each phase winding element connecting two terminals for powering;
- phase winding elements being connected in a star configuration or in a delta configuration (in a star configuration, the star point is also considered to be a terminal for powering);
- the elemental conductors being linear segments, piecewise linear segments, curved segments, s-shaped segments, bent lines or segments shaped in other ways;
- a line of movement being determined by the arrangement of the current loops;
- at least one current loops being substantially planar and magnetic field lines induced by the current loop, inside the current loop, being substantially linear;
- at least one current loop being, as seen from a perspective orthogonal to the layers, a (topological) circle;
- at least one boundary segments of a current loop being realized by elemental conductors or parts of elemental conductors;
- the current loops forming a periodic pattern along the line of movement, so that there exists at least one rolling pattern such that, after being rolled according to that rolling pattern, similar shaped current loops align and form at least one current loop of the cylindrical winding structure with higher magnetic flux (as compared to the individual magnetic flux of a current loop of the unrolled, planar winding structure).

A concatenation of elemental conductors (and vias) that runs essentially in one direction of the line of movement shall also be called a **half-loop.** Where a preferred direction of the line of movement is chosen, a half-loop running essentially in that direction shall be called a forward half-loop and a half-loop essentially running in the opposed direction shall be called a backward half-loop.

A **winding loop** is a series connection of
- a first half-loop that runs essentially in a first direction of the line of movement, and
- a second half-loop that runs essentially in a second direction of the line of movement, the second direction being opposed to the first direction of the line of movement, and
- optionally a third half-loop that runs essentially in the first direction of the line of movement,
that optionally also satisfies at least one of the following conditions:
- the length of the (orthogonal) projection onto the line of movement of the first and the third half-loop being essentially the same as to the length of the (orthogonal) projection onto the line of movement of the second half-loop; or
- the (orthogonal) projection onto the line of movement of the start of the first half-loop and the (orthogonal) projection onto the line of movement of the end of the last half-loop essentially coincide.

In the sense described above, a winding loop goes "once around" a winding structure. Heuristically a winding loop can be seen as an essentially closed structured line, e.g. an essentially closed zig-zag-line in three-dimensions that is flattened to (essentially) two-dimensions into the circuit structure. Therein, overlappings occur in different layers. Winding loops are (basic) elements out of which a winding structure realized as a circuit structure is created. The winding loops of a phase winding element can be connected in series or in parallel. Typically a winding loop comprises no two elemental conductors that contribute to a same boundary segment of a current loop, or in other words - and with the terminology introduced later - typically a winding loop comprises maximally a single elemental conductor per strand group.

A winding loop can start and end anywhere. For convenience's sake it typically makes sense to set the starting and the ending point of a winding loop such that the orthogonal projections of these points onto the line of movement substantially coincide with the orthogonal projection of one of or both of the terminals for powering the phase. However, sometimes it is beneficial to shift the starting and ending point of a winding loop away from the terminals for powering the phase, e.g. when describing a connection pattern in the proximity of the terminals for powering the phase.

In an embodiment, it can be the case that for at least one phase the two terminals for powering the phase are spatially close to each other.

In an embodiment, it can be the case that the start and the end of a winding loop are at the outermost (e.g. leftmost or rightmost) side of the layer and the third half-loop can be omitted, e.g. where the terminals for powering are at the outermost side of the layer.

In an embodiment, it can be the case that a winding loop starts at one terminal for powering the phase and ends at the other terminal for powering the phase.

In other words, a **winding loop** is a series connection of elemental conductors that begins at a location of a first terminal for powering the winding loop,
runs essentially in a first direction of the line of movement,
then runs essentially in a second direction of the line of movement that is essentially opposed to the first direction,
and optionally then runs essentially in the first direction, and
either
ends at a position whose orthogonal projection onto the line of movement is essentially identical to the orthogonal projection of the first terminal onto the line of movement
or
runs into a second terminal for powering the winding loop.

A **winding bundle** is a series connection of elemental conductors that comprises a series connection of one or more winding loops and that connects the two terminals for powering the winding phase element.
A winding bundle can comprise one or more winding loops. In particular a winding bundle can comprise only a single winding loop.

In an embodiment, it can be the case that at least one winding phase elements comprises winding loops that are geometrically parallel or substantially geometrically parallel to each other such that the induced magnetic fields superimpose. This allows generating magnetic fields of a higher flux.

In an embodiment, it can be the case that a winding structure is designed to extend along a line of movement in an electrical machine,
wherein the winding structure is realized as an flexible circuit structure and
where at least one winding phase element comprises at least two **winding loops.**

In an embodiment, it can be the case that at least one winding phase element comprises at least two winding loops that are connected in series.

In an embodiment, it can be the case that at least one winding phase element comprises at least two winding loops that are connected in parallel.

In an embodiment, it can be the case that at least one winding phase element comprises at least two or more winding bundles that are connected in parallel.

In an embodiment, it can be the case that every winding phase element comprises at least two or more winding bundles that are connected in parallel.

When a winding phase elements comprises parallel connected winding bundles one has to consider that the winding bundle, due to their arrangement, can have different induced voltages. For example, where all (strand) group connections in a winding phase element are order-preserving and/or mirroring, the induced voltages in the winding bundles can differ.

Such differences give rise to circular currents and corresponding losses, which reduce the efficiency of the machine.

Such losses can be reduced by changing the relative position of the winding loops and/or winding bundles in a winding phase element. Such changes can be made for the horizontal (intra-layer) and/or the vertical (inter-layer) position of the winding loops.

In an embodiment of the invention, it can be the case that the change of the relative positioning of the winding loops in a winding phase element occurs at the connection of strand groups. Strand groups are a set of elemental conductors that forms (or whose parts form) a segment of a current loop. In order to change the relative positioning of the winding loops the connections should not be made homogenously, but instead be - at least at some connections - *perturbed* from a homogenous pattern.

A concept of (sub-)groups allows for describing and defining specific 'minimal' perturbations that can be used to generate general perturbations, which shall be called elemental perturbations. Elemental perturbations can be classified into three different types.

Note that - as a general convention - a group can be a subgroup of itself.

By using elemental perturbations of type 1, the horizontal position of a winding loop relative to the other winding loops within the winding phase element can be altered. For example, a winding loop that is on the periphery of the strand group before a connection could become a winding loop in the middle of the strand group after the connection and vice versa.

By using elemental perturbations of type 2 or type 3, the vertical position of a winding loop relative to the other winding loops within the winding phase element can be altered.

By using perturbed connections, the horizontal and the vertical position of the winding loops relative to each other within the winding phase element can be altered almost arbitrarily.

By altering the relative position of the winding loops, the induced voltages can be controlled and if the connections are chosen adequately the circular currents can be reduced, thereby increasing the efficiency of the machine.

For a set of at least two elemental conductors in the same winding phase element that are substantially parallel to each other and arranged so that their current flows in the same direction, the induced magnetic fields superimpose. For calculating the field lines and the field strength the set of elemental conductors can be treated as a single conductor with a current flow (almost) equal to the sum of the current flows of the individual elemental conductors. Such a set shall be called a **group** (of elemental conductors).

In other words a group is a set of at least two elemental conductors
- that are in the same winding phase element,
- that are (geometrically) substantially parallel to each other and
- that are arranged so that their current flows in the same direction.

Note that the elemental conductors of a group do not necessarily have to be in a same layer.

A **strand group** (of elemental conductors) is a group (of elemental conductors) that forms (or whose parts form) a boundary segment of a current loop.

In other words a strand group is a group of at least two elemental conductors such that a boundary segment of a current loop is formed either
- by the elemental conductors of the strand group; or
- by a set that comprises a segment of each elemental conductor of the strand group.

Heuristically a strand group is a maximal group, namely if there was a group that comprised a strand group and an additional elemental conductor, because that elemental conductor is in the same winding phase, substantially parallel and arranged in the same direction, the elemental conductor would contribute to the same boundary segment - and hence already is in the strand group.

A boundary segment of a current loop not necessarily coincides with a side of a geometric form the boundary of the current loop forms. E.g. where the boundary of the current loop is a rhombus, a side of that rhombus can be formed of multiple segments, each formed by a different strand group.

In an embodiment of the invention, it can be the case that the elemental conductors of a group are **close** to each other.
In an embodiment, it can be the case that the maximal minimal distance between the members of the group is less than 1/20 or 1/50 or 1/100 or 1/200 or 1/500 or 1/1000 of the shortest elemental conductor of the group.

The set of vias that connect the elemental conductors of a first group to the elemental conductors of a second group shall be called a **group connection.** Where both groups are strand groups the group connection shall be called **strand (group) connection.**

Strand groups and groups shall be collectively denoted as "(strand) groups", especially where it is emphasized that a statement is valid for both.

In an embodiment, it can be the case that the diameter of the set of vias of a group connection is **small.**
In an embodiment, it can be the case that the diameter of the set of vias of a group connection is less than 1/20 or 1/50 or 1/100 or 1/200 or 1/500 or 1/1000 of the length of the shortest elemental conductor of at least one of the two groups connected by the group connection.

Typically each elemental conductor of a group is part of a different winding loop; in that sense one can speak of the winding loops in a group and of the winding bundles in a group.

Typically each winding loop comprises three or more elemental conductors. When a first elemental conductor is connected to a second elemental conductor by a via, the conductors are connected in series and are part of the same winding loops or are part of two winding loops that are connected in series. In the latter case, for the local viewpoint, it makes sense to shift the (abstract) start of the winding loops so that each connected pair of elemental conductors are part of the same (new) winding loop. In this sense two connected elemental conductors are a local representation of a winding loop, and one can speak of the winding loops in or of a group connection or a group.

In an embodiment, it can be the case that a strand group comprises at least two winding loops that are part of the same winding bundle.

In an embodiment, it can be the case that every strand group of a phase has the same number of elemental conductors and/or winding loops, respectively.

In an embodiment, it can be the case that every strand group comprises an elemental conductor of every winding loop of the winding phase element.

The elemental conductors of a group have a common current flow direction, so it makes sense to speak of a **chosen direction of the current flow** of a group or a strand group. Where an elemental conductor of one layer is galvanically connected by a via to a second elemental conductor of another layer a chosen direction of the current flow of the first elemental conductor defines the direction of the current in the second elemental conductor. Similarly, when a first group is connected to a second group by vias, a chosen (current) direction of the first group defines the direction of the second group. Similarly a chosen (current) direction of an elemental conductor of a winding loop defines the (current) direction of the winding loop and vice versa.

For a circuit structure the physical dimension in one of its principal axes is smaller than the physical dimension of the other two principal axes. The layers of conductors are substantially parallel. A chosen viewing direction orthogonal to (a layer of) the circuit structure therefore corresponds to a **chosen viewing direction orthogonal to each of the** (individual) **layers** or - in short - to a **chosen viewing direction orthogonal to the circuit structure.**

Where a winding structure is realized on a flexible circuit structure and the flexible circuit structure can be rolled to form a cylinder, the terms *'viewing direction orthogonal to each of the (individual) layers'* and *'viewing direction orthogonal to the circuit structure'* translate, by the transformation of rolling the flexible circuit structure, to the cylinder.

Where a current loop is planar and the magnetic field lines induced by the current loop, inside the current loop, are locally linear, the linear magnetic field lines, by the right-hand-rule, are parallel to the chosen viewing direction orthogonal to the layers.

Having chosen a direction of the current flow of an elemental conductor or of a group of elemental conductors and having chosen a viewing direction orthogonal to a layer it makes sense to speak of **"right" and "left"** in regard of substantially parallel elemental conductors in the same layer. For example "right" can be defined in the following way: form an orthogonal tripod of the thumb, the index and the middle finger of the right hand (in analogy to Fleming's right hand rule), where the thumb shows in the chosen viewing direction orthogonal to the circuit structure, where the index finger shows in the chosen direction of the current flow and the direction of the middle finger indicates right. If a layer of conductors is drawn on a piece of paper, i.e. top-down-view is chosen, and a direction of the current flow is chosen, this definition coincides with the common understanding of "right".

When a first elemental conductor of a first layer is connected to a second elemental conductor of a second layer, then a chosen direction of the current flow is propagated from the first elemental conductors to the second elemental conductor and thus - with respect to a chosen viewing direction orthogonal to the circuit structure - also the notion of "right" and "left" is propagated.

Note that "right" could also be chosen oppositional to the right hand rule or arbitrarily, as long as it is chosen consistently between the layers in the sense that it is consistent with the propagation of the current direction from one layer to another layer.

To summarize: a direction of the current flow of a winding phase element can be chosen consistently for all elemental conductors and winding loops of that phase. A viewing direction orthogonal to the (individual) layers can be chosen consistently for all layers, which shall also be called a viewing direction orthogonal to the circuit structure. Based on these two choices a notion of "left" and "right" can be chosen consistently for all elemental conductors and all winding loops in all layers.

A triple of a (consistently) chosen direction of the current flow, a (consistently) chosen viewing direction orthogonal to the layers and a (consistently) chosen notion of left and right shall be called an **orientation** (of a circuit structure). Where the circuit structure is flexible and rolled to form a cylinder, these terms, by the transformation of rolling, translate to a (local) orientation of the cylindrical circuit structure.

For the following embodiments - unless otherwise implied from the context - a winding structure realized as a circuit structure comprises the following features
- comprising two or more layers (of conductors);
- comprising one or more phase winding elements, the one or more phase winding elements each comprising two or more winding loops, each winding loops comprising one more elemental conductors, preferably comprising three or more elemental conductors;
- elemental conductors being linear segments, piecewise linear segments, curved segments, s-shaped segments, bent lines or segments shaped in other ways; and
- an orientation (of the circuit structure) being chosen.

In embodiments, it can be the case that at least one of or a combination of the following features are comprised:
- all current loops are planar;
- the current loops form an at least substantially periodic pattern along the line of movement;
- the circuit structure is flexible;
- the circuit structure is rolled - along the line of movement and according to a rolling pattern - to a cylinder;
- that some current loops of the unrolled, planar winding structure are - according to the rolling pattern - aligned and form at least one current loop of the cylindrical winding structure with higher magnetic flux (as compared to each of the magnetic flux of the individual current loops of the unrolled, planar winding structure).

For a group G1 whose elemental conductors are in a common layer L1, the notion of "right" and "left" defines a **left-right-order** or **horizontal order** on the elemental conductor. Note that this order is transitive, i.e. for a triple of substantially parallel elemental conductors R1, M1 and L1, such that R1 is right M1, M1 is right of L1, R1 is right of L1.

In an example where a coil is designed as a rhombus winding in a circuit structure, a first group, whose elemental conductors are in a first layer L1, can be connected to a second group, whose elemental conductors are in a second layer L2. In order to form (an edge of) a rhombus, the group connection would typically turn, that is to say the angle of the connection, as seen from the chosen viewing direction orthogonal to the circuit structure, coincides with the angle at the edge of the rhombus (that is significantly smaller than 180°, preferably between 50°-120°, preferably approximately 90°).

For such turning to be realized a connection typically is implemented as a so-called mirroring: For example where a first group comprising of three elemental conductors, denoted R1, M1, L1 in a first layer, where R1 is right of M1 and M1 is right of L1, is connected to a second group comprising of three elemental conductors, denoted R2, M2, L2 in a second layer, where R2 is right of M2 and M2 is right of L2, a mirroring occurs if the R1 is connected to L2, M1 is connected to M2 and L1 is connected to R1.

More generally, for an arbitrary group connection of a first group in a first layer and a second group in a second layer, a connection shall be called:
- **left-right-order preserving** or (horizontal) **order preserving** if, in accordance with the chosen orientation, the left-right-order before the connection is preserved after the connection. Or - in other words - if the rightmost elemental conductor of the first group is connected to the rightmost elemental conductor of the second group, the second rightmost elemental conductor of the first group is connected to the second rightmost elemental conductor of the second group, and so forth;
- **left-right-order mirroring** or simply (horizontal) **mirroring** if, in accordance with the chosen orientation, the left-right-order before the connection is mirrored after the connection. Or - in other words - if the rightmost elemental conductor of the first group is connected to the leftmost elemental conductor of the second group, the second rightmost elemental conductor of the first group is connected to the second leftmost elemental conductor of the second group, and so forth;
- **left-right-perturbation** or **horizontal perturbation** if the connection is neither (left-right-) order preserving nor (left-right-order) mirroring.

A horizontal perturbation of a subgroup connection, where the connected subgroups each comprise of three elemental conductors is called an **elemental perturbation of type 1.**

In other words: an elemental perturbation of type 1 occurs in a group connection if there exists a subgroup, comprising of a first triple of elemental conductors of a first group in a first layer, that is connected to a subgroup, comprising of a second triple of elemental conductors of a second group in a second layer, where, with respect to the chosen orientation,
- R1 is the most right elemental conductor of the first triple,
- M1 is the middle elemental conductor of the first triple,
- L1 is the most left elemental conductor of the first triple,
- R2 is the most right elemental conductor of the second triple,
- M2 is the middle elemental conductor of the second triple, and
- L2 is the most left elemental conductor of the second triple,
   and where one of the following four connections are made:
   1. R1 is connected to R2, M1 is connected to L2 and L1 is connected to M2 and,
   2. R1 is connected to M2, M1 is connected to R2 and L1 is connected to L2 and,
   3. R1 is connected to M2, M1 is connected to L2 and L1 is connected to R2 and,
   4. R1 is connected to L2, M1 is connected to R2 and L1 is connected to M2 and.

Every horizontal perturbation comprises a sub-group connection (recall that a group can be a subgroup of itself) that is an elemental perturbation of type 1. To verify whether or not a connection of a first group in a first layer to a second group in a second layer is a horizontal perturbation one needs to check if there exists a sub-group connection in the connection that is an elemental perturbation of type 1.

For a first elemental conductor of a group, whose elemental conductors are all in a first layer, a **neighbour** in this group is a second elemental conductor in this group that is next (among the elemental conductors of the group) to the first elemental conductor on the first layer. In other words a neighbour of a first elemental conductor of a group, whose elemental conductors are all in a first layer, is a second elemental conductor of that group, such that no other elemental conductor of that group is located in between the first and second elemental conductor.

An elemental conductor of a group of at least three elemental conductors, whose elemental conductors are all in a first layer, has one or two neighbours; two if it is in the middle of the group and one if it is on one of the two sides of the group. A neighbour of a first elemental conductor that is, according to the chosen orientation, to the left (right) of the first elemental conductor, shall be called the **left (right) neighbour** of the first elemental conductor. In a group whose elemental conductors are all located in a same layer and that comprises at least three elemental conductors, there is one elemental conductor that has a left neighbour but not a right neighbour (this elemental conductor shall also be called the **right side of the group)** and one elemental conductor that has a right neighbour but not a left neighbour (this elemental conductor shall also be called the **left side of the group).** Every other elemental conductor of the group has both a left and a right neighbour. The notion of neighbours is well defined for subgroups of a group. Note that the set of neighbours of an elemental conductor in a group can be different from the set of neighbours of an elemental conductor in a subgroup of that group. E.g. for a first group in a first layer comprising of five elemental conductors R1, RM1, M1, LM1, L1, where R1 is right of RM1, RM1 is right of M1, M1 is right of LM1 and LM1 is right of L1, the neighbours of M1 in the first group are RM1 and LM1; whereas in the subgroup consisting of R1, M1, L1 the neighbours of M1 are R1 and L1.

A **neighbour of a winding loop** A in a (sub-)group of elemental conductors is a winding loop B, such that an elemental conductor A1 that is the elemental conductor of the winding loop A in the (sub-)group, is a neighbour in the (sub-)group of an elemental conductor B1 that is the elemental conductor of the winding loop B in the (sub-)group.

On the level of winding loops horizontal perturbations can be described as follows:
A horizontal perturbation occurs in a group connection if at least one winding loop changes its set of neighbours at the group connection for at least one pair of (by the group connection) connected sub-groups. Where the sub-groups each consist of three elemental conductors, the sub-connection is an elemental perturbation of type 1.

In other words: An elemental perturbation of type 1 occurs in a group connection if a first subgroup of three elemental conductors that are in the first group and located in the first layer is, by the group connection, connected to a second subgroup of three elemental conductors that are in the second group and located in the second layer, where the three connected pairs of elemental conductors are each part of a winding loop, and where for at least one of the three winding loops the set of neighbours within the first subgroup is different from the set of neighbours within the second subgroup.

In an embodiment, it can be the case that a (strand) group comprises elemental conductors located in more than one layer.

A first embodiment with two layers that is rolled twice (720°) can - from the perspective of the coil - be similar to a second embodiment with four layers that is rolled once (360°). For instance where a *720°*-embodiment comprises a *360°*-periodic pattern in a first and second layer, a *360°*-embodiment can comprise the first *360°*-period in a first and second layer and the second *360°*-period in a third and fourth layer. For instance where the planar version of the *720°*-embodiment comprises two copies of a current loop whose strand groups each comprise *n* elemental conductors, the cylindrical winding structure, where the two copies overlap after rolling, comprises a current loop whose strands groups each comprise *2*n* elemental conductors; while the strand groups of the corresponding current loop of the *360°-*embodiment comprises 2**n* elemental conductors both in the planar and in the cylindrical version.

An embodiment with more than two layers can have the advantage of reduced external dimensions and can be advantageous for thick-walled and/or large windings.

In embodiments where (strand) groups can have elemental conductors in two or more different layers, it can be useful not only to perturb the horizontal order at a group connection, but also to perturb the vertical order of the winding loops. Vertical perturbations allow for more options for changing the relative positioning of the winding loops and can allow for a design of a winding structure (realized as a flexible circuit structure) with increased efficiency.

A **vertical perturbation** comprises at least one of the following sub-group connections:
- a (sub-)connection that brings two winding loops from different layers to a common layer (or vice versa); or
- a (sub-)connection where a first winding loop is on top (in the sense of layers) of a second winding loop on a first side of the connection and beneath (in the sense of layers) the second winding loop on a second side of the connection.

An **elemental perturbation of type** 2 occurs in a group connection in a flexible circuit structure comprising at least a first, a second and a third layer of conductors, where a first subgroup, comprising of a first pair of elemental conductors of the first (connected) group, is, by the group connection, connected to a second subgroup, comprising of a second pair of elemental conductors of the (connected) second group (200), and where
- the first pair comprises of a first elemental conductor and a second elemental conductor, and
- the second pair comprises of a third elemental conductor and a fourth elemental conductor,
   and where
- the first elemental conductor is connected the third elemental conductor, and
- the second elemental conductor is connected the fourth elemental conductor,
if the first elemental conductor and the second elemental conductor are located in the first layer, the third elemental conductor is located in the second layer and the fourth elemental conductor is located in the third layer.
In short: an elemental perturbation of type 2 connects two elemental conductors in a same layer to two different layers.
From the perspective of winding loops an elemental perturbation of type 2 occurs in a group connection in a flexible circuit structure (2) comprising at least three layers of conductors, if there exist at least two winding loops of the group connection such that
- one a first side of the group connection are located in a same layer, and
- one a second side of the group connection are located in different layers.
In short: an elemental perturbation of type 2 occurs in a group connection if two winding loops are in the same layer on the one side of the connection and are in different layers on the other side of the connection.
Recall that a chosen orientation comprises a chosen viewing direction orthogonal to the circuit structure. A chosen viewing direction orthogonal to a circuit structure implies a **top-bottom order** or **vertical order** of the layers of the circuit structure. Namely starting from outside the circuit structure and looking in the chosen viewing direction orthogonal to the circuit structure, one first sees a first layer (typically called the top layer), then a second layer, then a third layer (if it exists), etc. and finally a last layer (typically called the bottom layer). Typically the layers shall be numbered in their vertical order, namely the top layer is called layer one, the second layer is called layer two, the third layer (if it exists) is called layer three and so on. With respect to the chosen viewing direction orthogonal to the circuit structure it therefore makes sense to speak of a layer being **on top of** another layer or being **beneath** another layer. An **elemental perturbation of type 3** occurs in a group connection in a flexible circuit structure comprising at least two layers of conductors, and
a first subgroup, comprising of a first pair of elemental conductors of the first group (200), is, by the group connection, connected to
a second subgroup, comprising of a second pair of elemental conductors of the second group, where
- the first pair comprises of a first elemental conductor and a second elemental conductor, and
- the second pair comprises of a third elemental conductor and a fourth elemental conductor,
   and where
- the first elemental conductor is connected the third elemental conductor, and
- the second elemental conductor is connected the fourth elemental conductor,
   and where
- the first elemental conductor of the first pair in located in layer L1,
- the second elemental conductor of the first pair is located in layer L2,
- the third elemental conductor of the second pair is located in layer L3, and
- the fourth elemental conductor of the second pair is located in layer L4,
   and where
- the layer L1 is distinct from the layer L2,
- the layer L3 is distinct from the layer L4,
- the layer L1 is not necessarily distinct from one of the layer L3 or the layer L4,
- the layer L2 is not necessarily distinct from one of the layer L3 or the layer L4,
   if
- the layer L1 is located on top of the layer L2, and
- the layer L4 is located on top of the layer L3.
In short: an elemental perturbation of type 3 reverses the top-bottom-order of two via-connected elemental-conductor-concatenations.

In an embodiment, it can be the case that the circuit structure has four or more layers of conductors, and that an elemental perturbation of type 3 occurs, such that the layer L1, L2, L3, L4 are all mutually distinct.

From the perspective of winding loops an **elemental perturbation of type 3** in a group connection in a flexible circuit structure comprising at least two layers of conductors, if there exist at least a first winding loop of the group connection and a second winding loop of the group connection, such that
- one a first side of the group connection, the first winding is located in a layer on top of the layer in that the second winding loop located, and
- one a second side of the group connection, the second winding loop is located in a layer on top of the layer in that the first winding loop located.
In short: an elemental perturbation of type 3 reverses the top-bottom-order of two winding loops at a group connection.

An **elemental perturbation** is a group connection that is an elemental perturbation of type 1, an elemental perturbation of type 2 or an elemental perturbation of type 3.

A (strand) group connection of two (strand) groups shall be called a **perturbation** or **perturbed connection** if there exists at least one subgroup of the one group and at least one subgroup of the other group, such that the group connection restricted to the subgroups is an elemental perturbation, that is to say an elemental perturbation of type 1, an elemental perturbation of type 2 or an elemental perturbation of type 3. Note that a group is a subgroup of itself. For the sake of convenience a restricted connection is said to be comprised in the connection it is a restriction of.

The **elemental perturbations can generate perturbed connections** in the sense that perturbed connection are compositions of elemental perturbations, possibly of different type. Therefore by using perturbed connections the relative position of a winding loop relative to the other winding loops within the winding phase element can be altered with respect to their horizontal order and with respect to their vertical order. Thereby the relative position of the winding loops to each other can (almost) arbitrarily be altered at every (strand) connection.

In an embodiment, it can be the case that the winding structure is realized in two or more layers and that at least one winding phase element comprises at least one strand group connection that comprises at least one elemental perturbation of type 1.

In an embodiment, it can be the case that the winding structure is realized in three or more layers and that at least one winding phase element comprises at least one strand group connection that comprises at least one elemental perturbation of type 2.

In an embodiment, it can be the case that the winding structure is realized in two or more layers and that at least one winding phase element comprises at least one strand group connection that comprises at least one elemental perturbation of type 3.

In an embodiment, it can be the case that at least one winding phase element comprises at least one strand group connection that comprises at least one elemental perturbation of type 1 and at least one elemental perturbation of type 2 or type 3.

In an embodiment, it can be the case that at least one winding phase element comprises at least one strand group connection that is a perturbed connection.

In an embodiment, it can be the case that every winding phase element comprises at least one strand group connection that is a perturbed connection.

In an embodiment, it can be the case that a winding structure that is realized as a circuit structure comprises at least one or a combination of the following features:
- comprising two or more layers (of conductors);
- comprising one or more phase winding elements, the one or more phase winding elements each comprising one or more winding loops, where each winding loops comprises one more elemental conductors, each winding loop preferably comprising three or more elemental conductors;
- the elemental conductors being linear segments, piecewise linear segments, curved segments, s-shaped segments, bent lines or segments shaped in other ways; and
- an orientation (of the circuit structure) being chosen;
- vertical and/or horizontal perturbed connections being used to allow for a one- or two-dimensional variation of the positioning of the winding loops of a phase winding element relative to each other;
- the current loops being planar;
- the circuit structure being flexible and optionally being rolled - along the line of movement and according to a rolling pattern - to form a cylinder, so that at least some current loops of the unrolled, planar winding structure are - according to the rolling pattern - aligned and form at least one current loop of the cylindrical winding structure with higher magnetic flux (as compared to each of the magnetic flux of the individual current loops of the unrolled, planar winding structure).

In an embodiment, it can be the case that a flexible winding structure comprises at least two layers of conductors and comprises at least one winding phase element, the at least one winding phase comprising at least two winding loops;
the flexible winding structure further comprises at least one **group connection,** a group connection being a connection of a first group and a second group by vias, a group being a set of at least two elemental conductors
- that are in the same winding phase element,
- that are (geometrically) substantially parallel to each other, and
- that are arranged so that their current flows in the same direction,
where each two elemental conductors connected by the group connection are part of a winding loop, the set of these winding loops being called the **winding loops of the group connection;**
wherein at least one of the at least one group connection is a **perturbed connection,** a perturbed connection being a group connection that comprises at least one of the following
- a horizontal perturbation,
   a horizontal perturbation being a (sub-)connection that connects a set of winding loops of a first layer to a second layer and where the horizontal order of the set of winding loops is neither preserved nor mirrored; or
- a vertical perturbation,
   a **vertical** perturbation being at least one of the following sub-group connections:
   - a (sub)-connection that brings two winding loops from different layers to a common layer (or vice versa); or
   - a (sub)-connection that connects a first winding loop that is on top (in the sense of layers) of a second winding loop on a first side of the connection and beneath (in the sense of layers) the second winding loop on a second side of the connection.
In an embodiment, it can be the case that a flexible winding structure comprises at least two layers of conductors and comprises at least one winding phase element, the at least one winding phase comprising at least two winding loops;
the flexible winding structure further comprises at least one **group connection,** a group connection being a connection of a first group and a second group by vias, a group being a set of at least two elemental conductors
- that are in the same winding phase element,
- that are (geometrically) substantially parallel to each other, and
- that are arranged so that their current flows in the same direction,
where each two elemental conductors connected by the group connection are part of a winding loop, the set of these winding loops being called the **winding loops of the group connection;**
wherein at least one of the at least one group connection is a **perturbed connection,** a perturbed connection being a group connection that comprises at least one of the following **elemental perturbations:**
- an **elemental perturbation of type 1,** wherein the flexible circuit structure comprises at least a first and a second layer of conductors, and there exist three winding loops of the group connection, where, on a first side of the group connection, all three winding loops are located in the first layer, and where, on a second side of the group connection, all three winding loops are located in the second layer, and where the horizontal order of the three winding loops relative to each other is neither preserved nor mirrored;
- an **elemental perturbation of type 2,** wherein the flexible circuit structure comprises at least three layers of conductors, and there exist two winding loops of the group connection that
   - on a first side of the group connection are located in a same layer, and
   - on a first side of the group connection are located in different layers;
- an **elemental perturbation of type 3,** wherein the flexible circuit structure comprises at least two layers of conductors, and there exist at least a first winding loop of the group connection and a second winding loop of the group connection such that
   - on a first side of the group connection the first winding loop is located in a layer on top of the layer in which the second winding loop is located, and
   - on a first side of the group connection the second winding loop is located in a layer on top of the layer in which the first winding loop located.

In an embodiment, it can be the case that the winding structure comprises a (strand) group and
- that an order of the layers is chosen;
- that for each layer a notion of "left" and "right" for the elemental conductors of the (strand) group in the respective layer is chosen; and
- that each elemental conductor of the (strand) group is labelled - or indexed - by a natural number - called **index** - from *1* to *n*, where *n* is the number of elemental conductors of the (strand) group, and the labelling is done
   - in first priority from left to right (according to the chosen notion); and
   - in second priority from top layer to bottom layer (according to the chosen order).
In other words, the indexing is made in the following way:
- in the - according to the choice of the order of the layer - first layer that comprises one or more elemental conductors of the (strand) group, the elemental conductors are labelled from left to right - according to the notion of "left" and "right" chosen for that layer - starting with *1* for the most left elemental conductor and ending with *k* for the most right elemental conductor, where *k* is the number of elemental conductors of the (strand) group in that layer;
- in the - according to the choice of the order of the layer - next layer that comprises one or more elemental conductors of the (strand) group the elemental conductors are labelled from left to right - according to the notion of "left" and "right" chosen for that layer - starting with *k+1* for the most left elemental conductor and ending with *k+l* for the most right elemental conductor, where *l* is the number of elemental conductors of the (strand) group in that layer;
- the process is iterated for the - according to the choice of the order of the layer - next layers following the order of the choice of order of the layers.
Such labelling shall be called indexing and the (strand) group in such case should be called an indexed (strand) group.
Note that the indexing of the (strand) group depends on the choices for the order of the layer and for the notion of "left" and "right" on each layer.

Where an orientation is chosen
- the chosen viewing direction orthogonal to the circuit structure of the chosen orientation defines an order of the layers; and
- the notion of "left" and "right" of the chosen orientation defines a consistent notion of "left and "right" in each layer.
Thereby a choice of an orientation gives rise to a well defined indexing of a (strand) group. Such indexing shall be called the **indexing according to an orientation.**

For a given choice of orientation, every (strand) group can be indexed according to the orientation.

The line of movement of a winding structure has two directions. In an embodiment, it can be the case that the winding structure has a line of movement and that one of the two possible directions is chosen.

For
• - a (strand) group,
• - a (strand) group connection that connects the (strand) group to another (strand) group, and
• - a chosen direction of the line of movement,
• - a chosen order of the layers,
   an indexing - which shall be called line-indexing - can be defined as follows:
   - for each layer
      ∘ that comprises elemental conductors of the (strand) group,
   - (virtually) draw a (virtual) straight line segment,
      ∘ which shall be called an **index line (segment),**
   - that is parallel to the line of movement and
   - that intersects all elemental conductors of the (strand) group in that layer exactly once,
      ∘ if more than one such segment can be (virtually) drawn, choose the line segment such that the sum of the distances between the intersection points (of the elemental conductors and the line segment) and the respective vias of the (strand) group connection,
         ▪ the distance being measured as the distance within the respective elemental conductors,
      ∘ is minimal;
   - for each layer define a notion of "left" and "right" " for the elemental conductors of the (strand) group in the respective layer by the order defined by the order of the intersection points (of the elemental conductors and the line segment) according to the chosen direction of the line of movement,
      ∘ namely, an elemental conductor is the most right if its intersection point with the line segment is - among all intersection points of elemental conductors and the line segment in that layer - the one that lies furthest in the direction of the line segment defined by the chosen direction of the line of movement,
   - and index the elemental conductors according to the notion of "left" and "right" defined in this way and the chosen order of the layers,
      ∘ in particular where the indexing is done
      ▪ in first priority from left to right (according to the notion defined); and
      ▪ in second priority from top layer to bottom layer (according to the chosen order).

A (strand) group shall be called **line index-able with regard to the (strand) connection** - or in short **line index-able,** if the respective index lines can be drawn for each layer that comprises elemental conductors of the (strand) group.

For parallel connected winding bundles the relative position of the individual winding loops can be altered by choosing adequate strand connections. If the strand connections are chose favorably the circular currents can be reduced, thereby increasing the efficiency of the machine. According to the method of the invention for designing a winding structure for an electrical machine, an optimization procedure for reducing, preferably at least approximately minimizing, preferably nullifying the difference in induced voltages in parallel connected winding bundles influences or even determines the connections between the strand groups. The use of perturbed connection allows for much more complicated and variable connection patterns, so that the circular currents can be reduced beyond the reduction achieved by a litz wire.

For such optimization some connections can not be perturbed, because sometimes it can be preferable to use connection that is preserving or mirroring the horizontal order and preserving the vertical order. Other connections can be horizontally and/or vertically perturbed.

In an embodiment, it can be the case that the perturbed connections are chosen to reduce, preferably approximately minimize, preferably nullify the difference in the induced voltages between winding bundles that are connected in parallel.

In an embodiment, it can be the case that at least at least 10% or 30% or 50% or 70% or 90% of the strand group connection are perturbed connections.

In an embodiment, it can be the case that at least 10 or 50 or 100 or 500 or 1000 strand connections are perturbed connections.

In a method for reducing, preferably at least approximately minimizing, preferably nullifying the difference in induced voltages in parallel connected winding bundles, it can be the case that an optimization procedure is used to determine the connections appropriately.

In a method for designing a flexible winding structure comprising perturbed connections, it can be the case that a data processing unit is used to conduct an optimization procedure.

For practical purposes nullifying or almost nullifying the difference in the induced voltages by using perturbed connections is not always possible or desirable, because other practical aspects can restrict or influence the realization of the connection of the winding. These restricting or influencing factors are boundary conditions one has to respect when looking for a suitable connection pattern. Such boundary conditions could e.g. be limitation of the position of vias or elemental conductors to discrete locations on the flexible substrate.

In a method for designing a flexible winding (with at least two layers of conductors), it can be the case that, for at least some strand connections, perturbed connections are chosen to reduce, preferably at least approximately minimize, preferably nullify a difference in induced voltages in corresponding parallel connected winding bundles, in particular by using a data processing unit and/or an optimization procedure to determine the perturbations.

According to a variant, an optimization procedure respects boundary conditions.

According to a variant, a method comprises the following steps:
- choosing an initial pattern (for example being a pattern without perturbations) for a flexible winding structure (with at least two layers of conductors);
- defining a target function, whose value quantifies the amount of losses caused by circular currents in corresponding parallel connected winding bundles and whose variables comprise possible perturbations of the connections determined by the initial pattern for the flexible winding structure;
- determining a, possibly empty, set of boundary conditions;
- reducing, preferably at least approximately minimizing, preferably nullifying the target function with respect to the set of boundary conditions, preferably using a data processing unit and/or an optimization algorithm;
- creating a modified pattern for the flexible winding structure based on the result of the step of reducing, preferably at least approximately minimizing, preferably nullifying the target function with respect to the set of boundary conditions.

According to a variant, a method of designing a flexible winding structure (2) (with at least two layers of conductors) comprising elemental conductors in different layers being electrically connected by vias, wherein the elemental conductors are arranged and connected to form at least one winding phase element, comprises that the connections of the elemental conductors are chosen to reduce, preferably at least approximately minimize, preferably nullify a difference in induced voltages in corresponding parallel connected winding bundles, preferably by using a data processing unit and/or an optimization procedure to determine the connections of the elemental connectors.

According to a variant, a method comprises the following steps:
- choosing an initial pattern for a flexible winding structure (with at least two layers of conductors);
- defining a target function, whose value quantifies the amount of losses caused by circular currents in corresponding parallel connected winding bundles and whose variables comprise possible alternations of the connections of the elemental conductors that, by the initial pattern for the flexible winding structure, lie close to each other;
- determining a, possibly empty, set of boundary conditions;
- reducing, preferably at least approximately minimizing, preferably nullifying the target function with respect to the set of boundary conditions, preferably using a data processing unit and/or an optimization algorithm;
- creating a modified pattern for the flexible winding structure based on the result of the step of reducing, preferably at least approximately minimizing, preferably nullifying the target function with respect to the set of boundary conditions.

In an embodiment, it can be the case that the direction type (DT) of an elemental conductor is defined by its mean current flow direction along its total length, under the assumption of a stationary positive phase current, and the following four direction types for elemental conductors exist:
DT1: the mean current flow direction encloses an angle to the line of motion of *0°* to *90°*;
DT2: the mean current flow direction encloses an angle to the line of motion of *90°* to *180°;*
DT3: the mean current flow direction encloses an angle to the line of motion of *180°* to *270°;*
DT4: the mean current flow direction encloses an angle to the line of motion of *270°* to *360°.*
The angle system can be chosen arbitrarily. By the chosen orientation, in particular by the chosen viewing direction orthogonal to the circuit structure the angle system can be chosen consistently for all layers. We shall assume 0°-90° to point at the "upper right" and, by clockwise extension, 90°-180° to point at "lower right, 180°-270° to point at "lower left" and 270°-360° to point at "upper left", left and right here again referring to a chosen direction of the line of movement, up and down chosen so that a first terminal for powering the phase is located on the down-side of the winding.

The direction type DT1 is considered to be opposed to the direction type DT3 and the direction type DT2 is considered to be opposed to the direction type DT4.

In an embodiment, it can be the case that for at least one winding phase element, it can be the case that the elemental conductors of at least one strand group are all of the same direction type. Wheren all the elemental conductors of a strand group are of one direction type (DT1, DT2, DT3 or DT4) this strand group shall be said to be of that direction type (DT1, DT2, DT3 or DT4). A strand group of a direction type can comprise elemental conductors in one or more layers. As in general it can be the case that the individual elemental conductors can be linear segments, piecewise linear segments, curved segments, s-shaped segments, bent lines or segments shaped in other ways.

In an embodiment, it can be the case that for at least one winding phase element, it can be the case that every strand group is of a direction type.

In an embodiment, it can be the case that for at least one winding phase element, it can be the case that every strand group comprises the same number of elemental conductors.

In an embodiment, it can be the case that for at least one winding phase element the elemental conductors of each strand group is of a direction type at every strand group's terminal (determined by the mean current flow direction) a connection of the following **standard connections** (SC) are made:
SC1: a strand group of direction type DT1 is either connected to a strand group of direction type DT2 (upper end of the winding) or connected to a strand group of direction type DT4 (right end of the winding);
SC2: a strand group of direction type DT2 is either connected to a strand group of direction type DT1 (lower end of the winding) or connected to a strand group of direction type DT3 (right end of the winding);
SC3: a strand group of direction type DT3 is either connected to a strand group of direction type DT4 (at the lower end of the winding) or connected to a strand group of direction type DT2 (left end of the winding);
SC4: a strand group of direction type DT4 is either connected to a strand group of direction type DT3 (at the upper end of the winding) or connected to a strand group of direction type DT1 (left end of the winding).

Connections between conductors of orientation DT1 and DT2 as well as between conductors of orientation DT3 and DT4 are referred to as type T1 via connections. Connections between conductors of orientation DT1 and DT4 or between conductors of orientation DT3 and DT2 are referred to as type T2 via connections.

The **set of terminal strand groups** or - in short - **terminal set** (TS) of a phase winding element are the union of the strand groups of the phase winding element that comprise at least one elemental conductor that is a last (or first) elemental conductor of the phase winding element that is connected to a terminal for powering the phase.

In an embodiment, it can be the case that for at least one winding phase element that the terminal set comprises of either of the following:
TS1: a strand group of type D1 and - on the right thereof - a strand group of type D2;
TS2: a strand group of type D1 and - on the top thereof - a strand group of type D4;
TS3: a strand group of type D1 and - on the left thereof - a strand group of type D2;
TS4: a strand group of type D1 and - on the bottom thereof - a strand group of type D4;
TS5: a strand group of type D3 and - on the right thereof - a strand group of type D4;
TS6: a strand group of type D3 and - on the top thereof - a strand group of type D2;
TS7: a strand group of type D3 and - on the left thereof - a strand group of type D4; or
TS8: a strand group of type D3 and - on the bottom thereof - a strand group of type D2.
One or more elemental conductors of each terminal strand group can be (directly) connected to the terminals for powering. E.g. where all winding loops are connected in parallel, all elemental conductors of each terminal strand group can be (directly) connected to the terminals for powering and none elemental conductors of one first terminal strand group is (directly) connected to any elemental conductor of the other terminal strand group. By abuse of language the connection of the maximal connected subgroups of the terminal groups shall also be referred to as a strand group connection. In particular such connection could be a perturbed connection and/or being of a type T1 or T2 via connection.

In an embodiment of a winding structure, it can be the case that for at least one winding phase element it can be the case:
that the individual elemental conductors are linear segments, piecewise linear segments, curved segments, s-shaped segments, bent lines or segments shaped in other ways; and
that all strand groups are of a direction type and have elemental conductors in one or more layers; and
that all strand group connections are standard connections; and
that optionally every strand group comprises the same number of elemental conductors.

Such embodiment shall be called a **direction type model** of a winding phase element. As noted before, by abuse of language, the (possibly virtual) connection of the terminal strand groups is one of the even numbered T1 or of the two T2 via connections. A way of connecting the strand groups is to use T1 via connections that are horizontal order mirroring and vertical order preserving, and T2 via connections that are horizontal and vertical order preserving. In that case no connection is perturbed, and the structure of the winding bundles (i.e. how many are connected in parallel, how many winding loops are connected in series for each individual winding bundle) can be determined by the connections chosen between the two terminal strand groups and the terminals. By a choice the winding loops in this case can start in the one terminal strand group and end in the other. For convenience this convention can be changed when the winding loops of the connection of the terminal strand groups are considered, i.e. so that the winding loops start and end somewhere else. Where every strand group has the same number of elemental conductors, say *n*, it can be the case that the number of winding loops is *n.* In a variant of this embodiment, it can be the case that at least some of the strand connections can be perturbed horizontally and/or vertically, so that the relative positioning of the winding loops is changed. Perturbations can occur at the T1 and/or at the T2 via connections, including the connection between the two terminal strand groups.

The subject matter of the invention will be explained in more detail in the following text with reference to exemplary embodiments that are illustrated in the attached drawings, which schematically show:
- Figure 1: A sectional view of an electrical machine with an air-gap winding.
- Figure 2: A perspective view of a section of an example of a circuit structure with two layers.
- Figure 3: A winding scheme comprising three winding phase elements, where each winding phase element comprises a single winding loop.
- Figure 4: A winding scheme comprising a single winding phase element that comprises a single winding bundle comprising of three winding loops connected in series.
- Figure 5: A winding scheme comprising a single winding phase element that comprises a single winding bundle comprising of three winding loops connected in parallel and without elemental perturbations/perturbed connections.
- Figure 6: A winding scheme comprising a single winding phase element that comprises a single winding bundle comprising of three winding loops connected in parallel and comprising elemental perturbations/perturbed connections.
- Figure 7: A horizontal perturbation.
- Figure 8: A perturbed connection in a circuit structure with four layers comprising a horizontal perturbation that is an elemental perturbations of type 1.
- Figure 9: A perturbed connection in a circuit structure with four layers comprising a vertical perturbation that is an elemental perturbations of type 2.
- Figure 10: A perturbed connection in a circuit structure with four layers comprising a vertical perturbation that is an elemental perturbations of type 3.
- Figure 11: A perturbed connection in a circuit structure with four layers comprising multiple perturbations.
- Figure 12: An example of a perturbed connection connecting a first groups and a second group on a 4-layer FPC.
- Figure 13: An example of an index perturbation, where the indexing is according to an orientation.
- Figure 14: Examples of line indexing, examples of group connections that are not index perturbations according to the line index and an example of a group connection that is an index perturbation according to the line index.

In principle, identical parts are provided with the same reference symbols in the figures.

**Figure** 1 shows a sectional view of an electrical machine 1 with an air-gap winding 12. A rotor with a permanent magnet 15 surrounded by a sleeve 14 is arranged to rotate relative to a stator with a core 11. Between the rotor and the core 11 an air-gap 13 for the magnetic field of the permanent magnet 15 is present. The air-gap winding 12 is arranged in this gap, in contrast to electrical machines where the windings are arranged around pole shoes that are part of the stator. Radii of the various elements are denoted by *R₁-R₅,* a relative angle between stator and rotor by *θ*. The air-gap winding 12 is drawn in a highly schematic manner that does not reflect details of the following embodiments. The air-gap winding can be realized by a flexible winding structure rolled up form a cylinder.

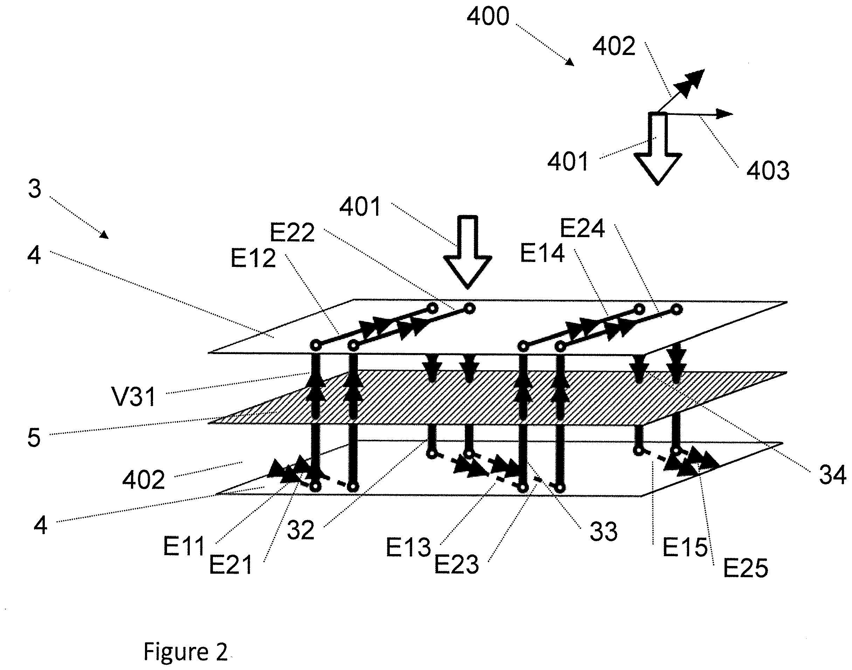

**Figure 2** shows a perspective view of part of a **winding structure 2** realized as a **circuit structure 3** with two **conductive layers 4.** An **insulating layer 5** is arranged between each pair of conductive layers. Typically only the conductive layers are counted and mentioned, so a "flexible circuit structure with two layers" typically addresses a flexible circuit structure with two conductive and at least one insulating layers. Additional insulating layers can be arranged to insulate the outward sides of the two conductive layers. The arrow indicates a chosen **viewing direction orthogonal to** the layers respectively the **circuit structure 401.** Here the top-view from above is chosen. The layer on top is called top-layer and the layer on the bottom is called bottom-layer. When a circuit structure features more than two layers, the layers are numbered starting with the top-layer, so that the top-layer is referred to as layer one, the next layer in the chosen direction is referred to as layer two and so on.

On the conductive layers elemental conductors *E11, E12, E13, E14, E15, E21, E22, E23, E24, E25* are placed, which typically start and end at vias 31, 32, 33, 34. E.g. a via *V31* galvanically connects an elemental conductor *E11* of one conductive layer to an elemental conductor *E12* of another conductive layer, and therefore passes through the insulating layer. A via can connect two elemental conductors located in neighbouring conductive layers or in distant layers, possibly passing through more than one insulating layer.

In Figure 2 a first set of vias 31, 32, 33, 34 connects a first set of elemental conductors *E11, E12, E13, E14, E15* in a first series. The elemental conductors connected in series can form winding loops and winding bundles. Figure 2 shows a second series connection comprising a second set of elemental conductors *E21, E22, E23, E24, E25* connected by a second set of vias. The second series connection is geometrically parallel to the first series connection. The elemental conductors in layer one are drawn as lines, the elemental conductors in layer two are drawn as dashed lines.

If a direction of the current flow is chosen for a first elemental conductor, then the direction can consistently be chosen for all elemental conductors with which the first elemental conductor is connected in series. In Figure 2, double-arrows 402 indicate the chosen direction of the current flow. An orthogonal tripod 400 indicates how the direction "right" 403 can be defined intrinsically, based on the choices of the viewing direction orthogonal to the flexible circuit structure 401 and the direction of the current flow 402. The notion of "right" 403 and "left" can be chosen consistently for all layers. In the embodiment of Figure 2
- the elemental conductor *E11* is located on the right of elemental conductor *E21,*
- the elemental conductor *E*22 is located on the right of the elemental conductor *E12,*
- the elemental conductor *E13* is located on the right of the elemental conductor *E23,*
- the elemental conductor *E24* is located on the right of the elemental conductor *E14* and
- the elemental conductor *E15* is located on the right of the elemental conductor *E25.*
Note that the elemental conductors of the first series connection are alternating right and left of the second series connection. This alternation occurs because the depicted group connections are mirroring the horizontal order.

**Figure 3** shows a scheme of a winding structure 2 for implementation in a flexible circuit structure 3, e.g. a flexible printed circuit (FPC), from the top-down viewing direction.
The winding scheme is drawn for zero to *720*°, indicating that the flexible printed circuit has to be rolled twice to obtain a cylindrical winding for use in a rotation machine. The shown pattern is periodic; it is repeated every *360°* and can be continued to any multiple *n* of *360°,* in which case the flexible printed circuit must be rolled *n* times. The winding could also end at an odd multiple (greater or equal to three) of *180°,* which however can result in an asymmetry when rolled.
The winding scheme shown in Figure 3 shows three **winding phase elements 6,** each connected to two **terminals of powering 7**. The circuit structure 3 in this example comprises two conductive layers, layer one and layer two. The elemental conductors on layer one are drawn as solid lines, whereas the elemental conductors on layer two are drawn as dashed lines. The elemental conductors on layer one are connected to the elemental conductors on layer two by via connections.
Every **winding loop 50** in Figure 3 is comprised of a series connection of
- a first half-loop starting from the left and going to the right, i.e. going **forward;**
- a second half-loop starting from the right and going to the left, i.e. going **backward;**
- and a (very short) third half-loop comprising of a single elemental conductor starting from the left and going to the right, i.e. going forward (in a case where the terminals for powering are at a peripheral location of the winding, such as short edges of the circuit structure, this third half-loop can be omitted);
and the ends of the two forward half-loops are connected to the respective **terminals for powering 7** of the respective winding phase element. In a general case a winding loop can also be connected to other winding loops.
A **winding bundle 51** is a series connection of winding loops that is maximal in the sense that it connects the two terminals for powering a winding phase element. Multiple winding bundles in a winding phase element can be connected in parallel.
In the embodiment shown in Figure 3 each winding phase element comprises of a single winding bundle and each winding bundle comprises a single winding loop. Each winding loop comprises ten elemental conductors, five in layer one and five in layer two.
Each phase comprises four current loops in the shape of a diamond and, when the flexible circuit structure is rolled twice, they superimpose to form two circular loops and hence a single **pole pair.**

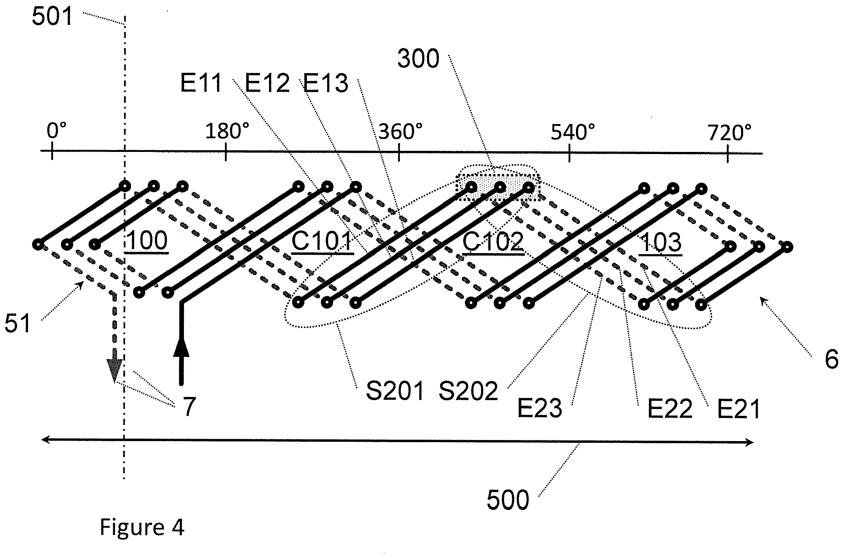

**Figure** 4 shows a scheme of a single winding phase element 6 of a winding structure 2 for implementation in a flexible circuit structure 3, e.g. a flexible printed circuit (FPC), from the top-down viewing direction. Note that more phases are possible and, for example, can be a slightly side-shifted clone of the winding phase element shown in Figure 4.
The winding phase element shown in Figure 4 comprises one winding bundle that comprises three winding loops connected in series.

The elemental conductors *E11, E12, E13* are
- in the same winding phase element,
- substantially parallel to each other, and
- arranged so that their current flows in the same direction,
so that the induced magnetic fields superimpose. Such a set shall be called a **group** (of elemental conductors).

A **current loop** of a winding structure is a, possibly virtual, circuit that gives rise to a magnetic field that, inside the circuit, has almost linear magnetic field lines. The winding of Figure 4 shows four current loops 100, *C101, C102,* 103. In this case the current loops all have the shape of a diamond.

The current loop *C102* is a virtual circuit. That means it is not a single electrical loop, but, in this case, a combination of segments that geometrically form a loop but are not directly physically connected. From the perspective of the current loop, the currents of these segments are aligned so that a superimposed magnetic field is created. Its field lines intersect the plane of the current loop at a right angle.

Seen from the perspective of the current loop *C102,* the upper-left boundary segment of the diamond-shaped current loop is made of the three upper-right-halves of the elemental conductors *E11, E12, E13.* The elemental conductors *E11, E12, E13* not only constitute a group, denoted in Figure 4 by *S201,* but their respective upper-right-halves together form the upper-left boundary segment of the current loop *C102.* A group that, or whose parts, form a boundary segment of a current loop shall be called a **strand group.** Note that the group *S201* also forms a strand group with regard to the current loop *C101.* Furthermore note that the elemental conductors *E11* and *E12* by themselves also form a group but not a strand group, because, although their halves contribute to a boundary segment of the current loop, they are not the full set of elemental conductors which or whose part contribute to the respective boundary segments.

A connection of two groups by vias shall be called a group connection 300. Where both groups are strand groups, the group connection shall also be called a strand group connection. The first (strand) group *S201* comprising the elemental conductors *E11, E12, E13* and the second (strand) group *S202* comprising the elemental conductors *E21, E22, E23* are connected by a (strand) group connection 300.

The line of movement 500 of a coil of an electrical machine is defined by the arrangement of the current loops, which induce the varying magnetic fields. For the planar embodiment of Figure 4 the line of movement is linear and horizontal.

The three winding loops each start at a location 501, indicated by a dash-dot line, on the line of movement, which lies in the region of terminals for powering 7.

The embodiment shown in Figure 4 is also a direction type model:
- each elemental conductors is a linear segment;
- two strand groups are of type DT1, three strand groups are of type DT2, three strand groups are of type DT3 (one of which being the strand group *S201),* two strand groups are of type DT4 (one of which being the strand group *S202),* and every strand group respectively comprises only elemental conductors in a single layer;
- two strand connections are of type SC1-T1, two strand connections are of type SC2-T1 (one of which being the terminal set of type TS3), two strand connections are of type SC3-T1, two strand connections are of type SC4-T1, one strand group is of type SC2-T2 (left end) and one strand group is of type SC3-T2 (right end); and
- every strand group consists of exactly three elemental conductors.
In this case most of the elemental conductors and strand groups extends over one motor/generator pole (corresponding to *180*°), with the exception of the four strand groups to the far left respectively far right that extend over half a motor/generator pole (corresponding to 90°). By the choices made for the terminal set connection, two of the three possible connections are made to connect the winding loops in series, while one of the possible connections is degenerated and the two 'loose' ends are respectively connected to one terminal for powering. Consequently all three winding loops are connected in series to form a single winding bundle.

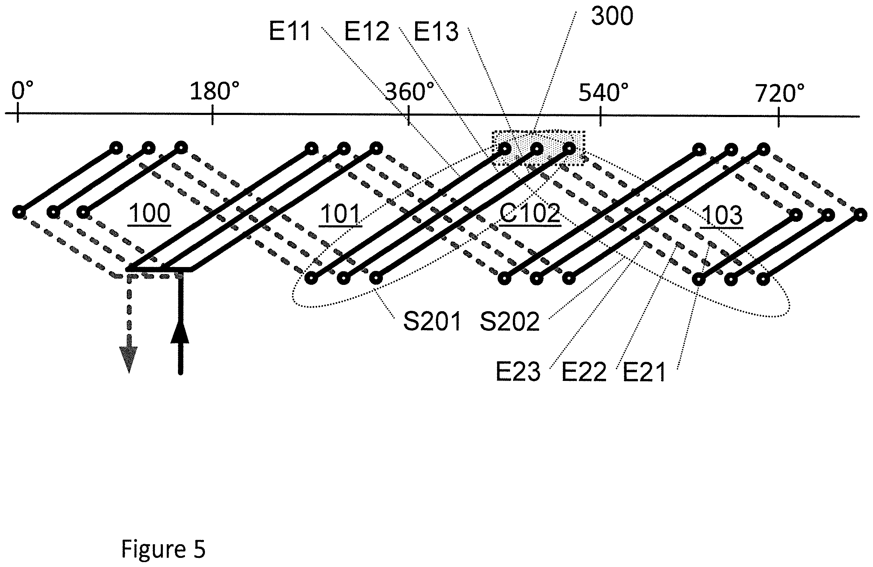

**Figure 5** shows a scheme of a single winding phase element 6 of a winding structure 2 for implementation in a flexible circuit structure 3, e.g. a flexible printed circuit (FPC), from the top-down viewing direction. Note that more phases are possible. E.g. additional phases could be shifted copies of the winding phase element shown.
The winding phase element shown in Figure 5 comprises of three winding bundles, each of which comprising of a single winding loop, that are connected in parallel. For parallel connections of winding bundles, the different winding bundles, due to their geometrically different arrangement in the circuit structure, have different induced voltages. Therefore, circular currents can be induced in the winding bundles, which compromise the machine's efficiency.

The elemental conductors *E11, E12, E13* form a first group *S201* and the elemental conductors *E21, E22, E23* form a second group *S202.* These groups *S201, S202* are connected by a group connection 300. Choosing the direction of the current flow as indicated by the arrows at the terminals for powering and the top-down view orthogonal to the layers (i.e. looking *onto* the paper-plane), the notion of *'right'* can be chosen e.g. by a right hand tripod (thumb in direction of the current flow, index finger in the direction of the orthogonal view, then the middle finger points at "right"). With this choice the elemental conductor *E11* is to the right of the elemental conductor *E12,* and the elemental conductor *E12* is to the right of the elemental conductor *E13.* Likewise in layer two, with respect to the propagated choice of 'right', the elemental conductor *E21* is to the right of the elemental conductor *E22*, and the elemental conductor *E22* is to the right of the elemental conductor *E23.*
In the example shown in Figure 5 the group connection connecting the first group *S201* and the second group *S202* is horizontal order **mirroring** , namely
- the "left" elemental conductor *E23* is connected to the "right" elemental conductor *E11,*
- the "middle" elemental conductor *E22* is connected to the "middle" elemental conductor *E12,* and
- the "right" elemental conductor *E21* is connected to the "left" elemental conductor *E13.* The embodiment shown in Figure 5 comprises two order preserving strand group connections (the one all the way to the left and the one all the way to the right), while all other strand connections are order mirroring.
The embodiment shown in Figure 5 is also a direction type model, similarly to the embodiment shown in Figure 4, but with different choices for the terminal set connection. Namely in the embodiment shown in Figure 5 all three of the three possible connections are degenerated and the three pairs of 'loose' terminals are connected to the terminals for powering. Consequently the three winding loops are connected in parallel.

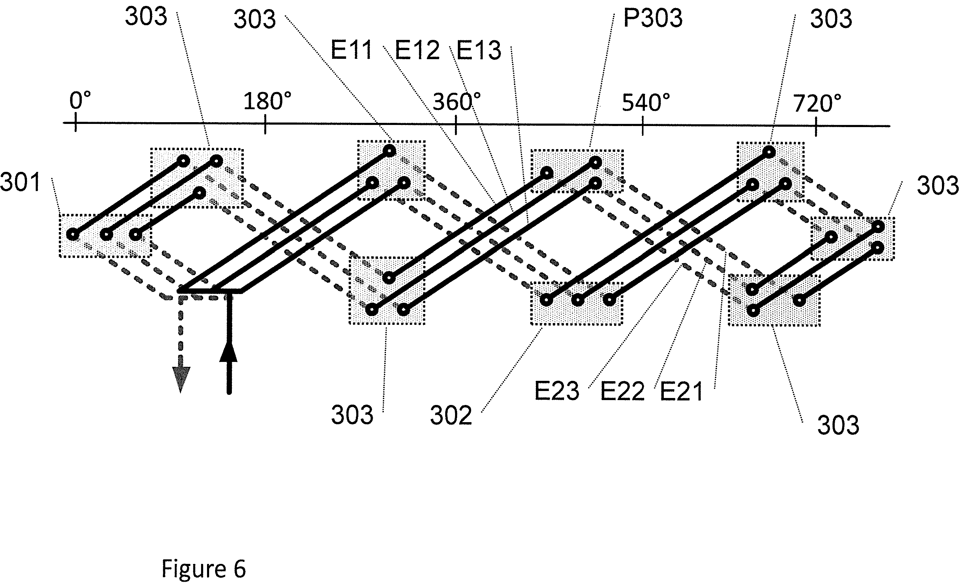

**Figure 6** shows a winding scheme similar to that of Figure 5, but in the embodiment of Figure 5 some of the strand group connections are (horizontally) perturbed.
For example in the group connection *P303* in Figure 6
- the "left" elemental conductor *E23* is connected to the "right" elemental conductor *E11,*
- the "middle" elemental conductor *E22* is connected to the "left" elemental conductor *E13,* and
- the "right" elemental conductor *E21* is connected to the "middle" elemental conductor *E12.*

A group connection between two groups, whose respective elemental conductors are all located in one respective layer and whose left-order is neither preserved nor mirrored, shall be called a horizontal perturbation. A horizontal perturbation, where the connected groups each are composed of three elemental conductors, shall also be called an elemental perturbation of type 1. The group connection *P303* therefore is a horizontal perturbation and in particular an elemental perturbation of type 1.

From the perspective of the winding loops, on one side of the connection, the winding loop that comprises elemental the conductors *E23* and *E11* only has one neighbour, namely the winding loop that comprises the elemental conductor *E22* and *E13.* On the other side of the connection, the winding loop that comprises elemental conductor *E23* and *E11* still only has one neighbour, but the new neighbour is the winding loop that comprises elemental conductors *E21* and *E12.* A group connection of winding loops between two groups, whose respective elemental conductors are all located in one respective layer, and where at least one winding loop that is connected by the group connection has a different set of neighbours on the one side of the connection than it has on the other side of the connection, amounts to a horizontal perturbation. Where the connected groups are composed of three elemental conductors a horizontal perturbation shall also be called an elemental perturbation of type 1.

By using perturbed connections for connecting the strand groups in a winding structure with winding bundles that are connected in parallel, the positioning of the winding loops and/or winding bundles relative to each other can be changed at every strand group connection. Thereby the voltages induced in each winding loop and/or winding bundle can be controlled. By choosing the perturbation connections appropriately, the losses due to circular currents can be reduced.

In order to reduce, preferably approximately minimize, preferably nullify the difference in induced voltages in the corresponding winding bundles, not every strand group connection has to be perturbed. Like in the example shown in Figure 6 a winding structure can comprise a mixture of order preserving connections 301, order mirroring connections 302 and perturbed connections 303.

The embodiment shown in Figure 6 is, similarly to the embodiment shown in Figure 5, a direction type model.

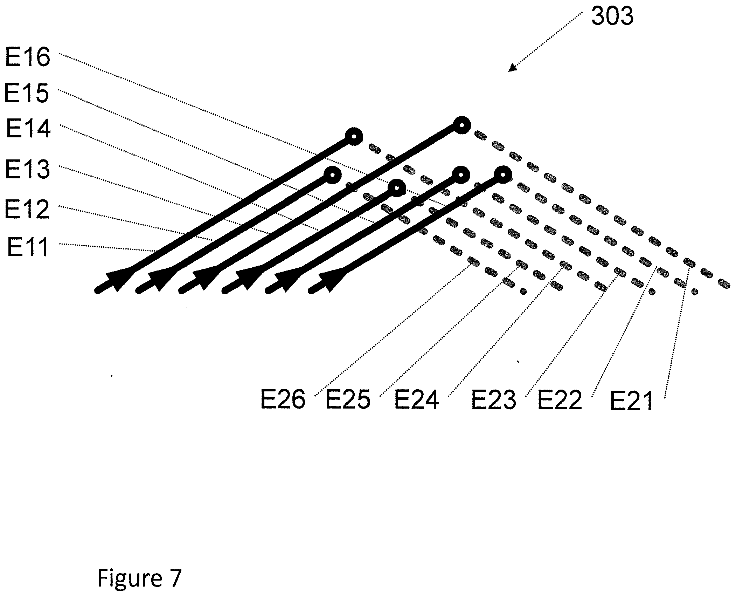

**Figure** 7 shows a magnified view of a perturbed connection connecting two groups. The first group is composed of six elemental conductors E11, E12, E13, E14, E15, E16, drawn as lines, that are located in a first layer. The second group is composed of six elemental conductors E21, E22, E23, E24, E25, E26, drawn as dashed lines, that are located in a second layer. Therefore the connection can only allow for horizontal perturbations, for otherwise at least one of the two groups would have to comprise two elemental conductors located in different layers.
The connection pattern is more complex than in the examples described before. For determining whether or not the connection from a single layer to another single layer is horizontally perturbed, one can check the sub connections of the sets of triplets. If at least of sub-connection of a pair of triplets is an elemental perturbation of type 1, the connection is a horizontal perturbation.
In Figure 7, for example, the triple composed of the elemental conductors *E11, E12, E13* is connected to the triplet composed of the elemental conductors *E21, E24* and *E26.* For the respective triplets (and the indicated orientation) the elemental conductors *E11* and *E21* are on the left, the elemental conductors *E12* and *E24* are in the middle and the elemental conductors *E13* and *E26* are on the right. Therefore
- the "left" elemental conductor *E11* is connected to the "middle" elemental conductor *E24,*
- the "middle" elemental conductor *E12* is connected to the "right" elemental conductor *E26,* and
- the "right" elemental conductor *E13* is connected to the "left" elemental conductor *E21.* Therefore this sub-group connection on the indicated pair of triples is neither order preserving nor mirroring and hence is an elemental perturbation of type 1. Consequently the group connection as shown in Figure 7 is horizontally perturbed.
The connection shown in Figure 7 comprises more than one pair of triples for which the restriction of the group connection is a perturbation of type 1.

From the perspective of the winding loops, the winding loop that comprises elemental conductor *E11* and *E24* before the connection only has one neighbour, namely the winding loop that comprises elemental conductor *E12* and *E26.* After the connection the winding loop that comprises elemental conductor *E11* and *E24* has two neighbours. Therefore this winding loop changes its set of neighbours at the connection. A group connection from a first to a second layer, where at least one winding loop has changed its set of neighbours, is a (horizontally) perturbed connection. As well this can be checked on a sub-connection on a pair of triples.

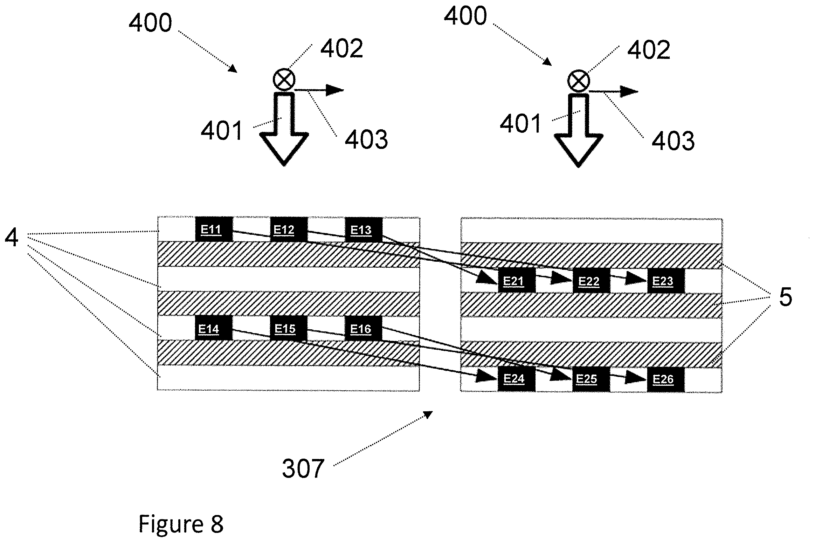

**Figure 8 to Figure 11** show sketches of two cross-sections (orthogonal to the layers) of a flexible circuit structure with four layers of conductors 4. The ruled layers symbolize insulating layers 5. The orthogonal tripod 400 indicates the chosen respective orientation. The circle with a cross 402 indicates that in all cases the chosen direction of the current flow is the direction into the paper plane.
The arrows between the elemental conductors indicate the connection pattern. The left cross-section is taken shortly before the connection and the right cross-section is taken shortly after the connection.

**Figure 8** shows an example of a perturbed connection 307 that comprises two sub-connections that are elemental connections of type 1. The connection connects a first group, comprising of the elemental conductors *E11, E12, E13* in layer one and the elemental conductors *E14, E15, E16* in layer three, and a second group, comprising of the elemental conductors *E21, E22, E23* in layer two and the elemental conductors *E24, E25, E26* in layer four.

The (sub-) connection of the subgroup comprising of the elemental conductors *E11, E12, E13* in layer one and the subgroup comprising of the elemental conductors *E21, E22, E23* in layer two is an elemental perturbation of type 1, because the winding loop comprising elemental conductors *E11* and *E22* only has one neighbour before the connection, but two neighbours after the connection.

The (sub-) connection of the subgroup comprising of the elemental conductors *E14, E15, E16* in layer three and the subgroup comprising of the elemental conductors *E24, E25, E26* in layer four is an elemental perturbation of type 1, because the winding loop comprising elemental conductors *E14* and *E24* changes its set of neighbour at the connection. Before the connection the only neighbour is the winding loop comprising the elemental conductors *E15* and *E26,* after the connection the only neighbour is the winding loop comprising the elemental conductors *E16* and *E25.*

Therefore the connection 307 as shown in Figure 8 is a perturbed connection, where the horizontal order is perturbed. No elemental perturbation of type 2 or 3 occurs, or equivalently, the connection is preserving the vertical order.

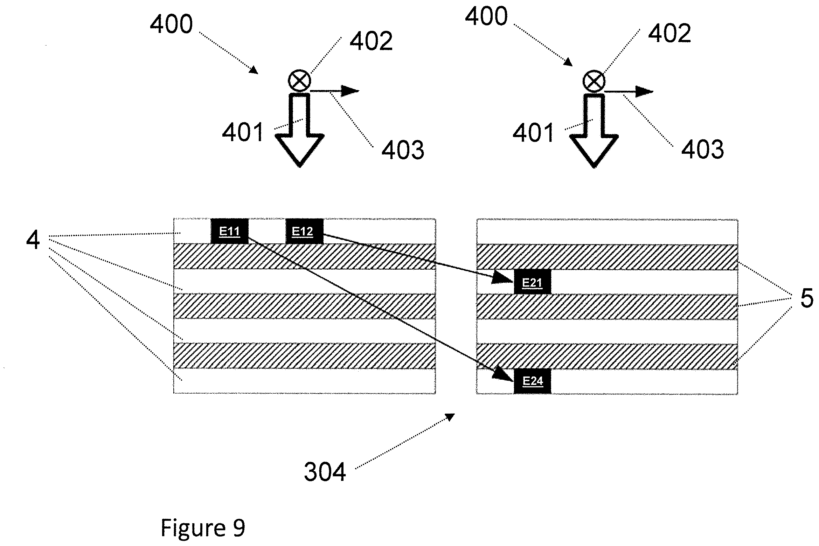

**Figure 9** shows an example of a perturbed connection 304 that amounts to an elemental perturbation of type 2. A first group, comprising of the elemental conductor *E11* in layer one and elemental conductor *E12* in layer one, is connected to a second group, comprising of the elemental conductor *E21* in layer two and elemental conductor *E24* in layer four.

Two conductors that are located in the same layer, namely elemental conductors *E11* and *E12* in layer one, are connected to two elemental conductors that are in different layers, namely elemental conductors *E21* in layer two and elemental conductor *E24* in layer four. Thereby the group connection 304 shown in Figure 9 is a vertical perturbation, more specifically an elemental perturbation of type 2.

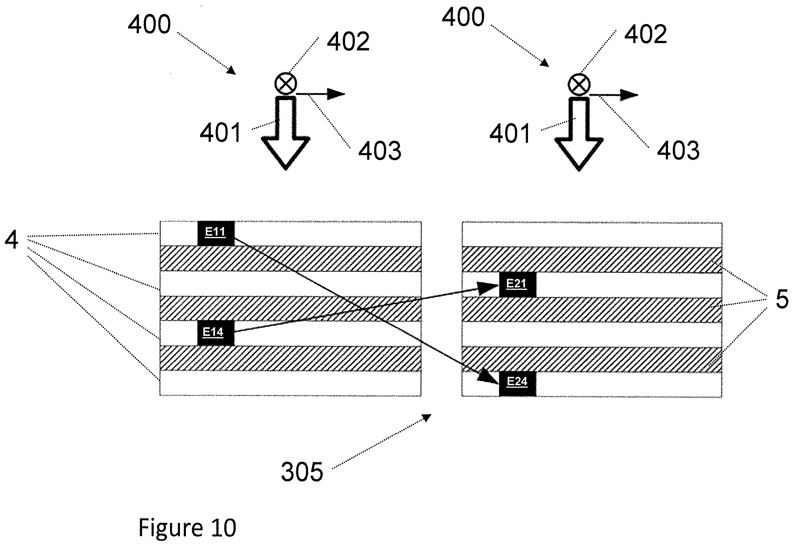

**Figure 10** shows an example of a perturbed connection 305 that amounts to an elemental perturbation of type 3. A first group comprising of the elemental conductor *E11* in layer one and elemental conductor *E14* in layer three, is connected to a second group comprising the elemental conductor *E21* in layer two and elemental conductor *E24* in layer four.
The elemental conductor *E11* in layer one is connected to the elemental conductor *E24* in layer four, and the elemental conductor *E14* in layer three is connected to the elemental conductor *E21* in layer two.
Since layer one is, with respect to the orientation 400, on top of layer three, but layer two is on top of layer four, the connection reverses the vertical order. Thus the connection 305 shown in Figure 10 is a vertical perturbation, more specifically an elemental perturbation of type 3.

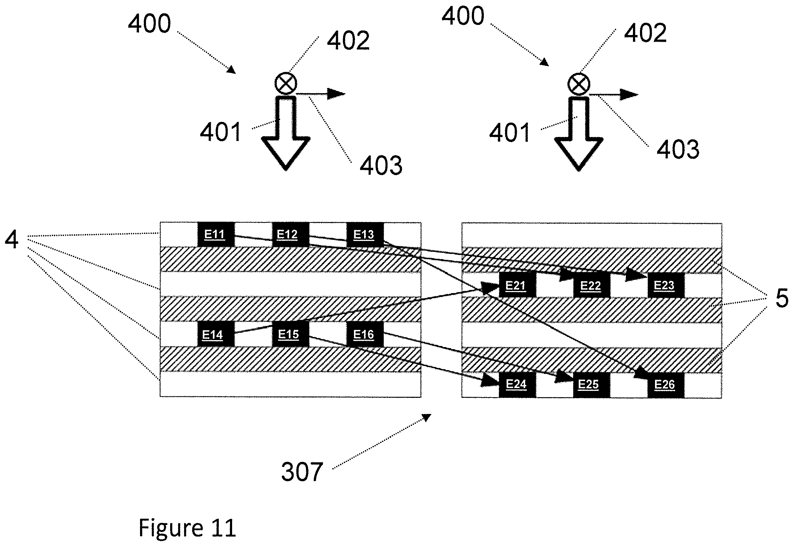

**Figure 11** shows an example of a perturbation connection that is the composition of various elemental perturbations.

Take for example the (sub-) group comprising of the elemental conductor *E13* and *E14;* and the (sub-) group comprising the elemental conductor *E21* and *E26.* The elemental conductor *E12* in layer one is connected to the elemental conductor *E26* in layer four, and the elemental conductor *E14* in layer three is connected to the elemental conductor *E21* in layer two. This (sub-) group connection is a vertical perturbation, more specifically an elemental perturbation of type 3.

Another example is the connection of the pair comprising elemental conductors *E12* and *E13* that is connected to the pair comprising of the elemental conductors *E23* and *E26*. While the first pair is in a same layer, the second pair is in two different layers. Hence the (sub-) group connection of the two pairs is a vertical perturbation, more specifically an elemental perturbation of type 2.

Because the connection 307 shown in Figure 11 comprises at least one perturbed sub-group connection, the connection 307 is a perturbed connection.

On an abstract level the perturbed connection 307 shown in Figure 11 can be regarded as (clock-wise 90°-) rotation.

Note that much more complex connections patterns than shown in the examples could be used in embodiment. A strand group of a perturbed connection could comprise for dozens or hundreds or thousands or more elemental conductors respectively winding loops.

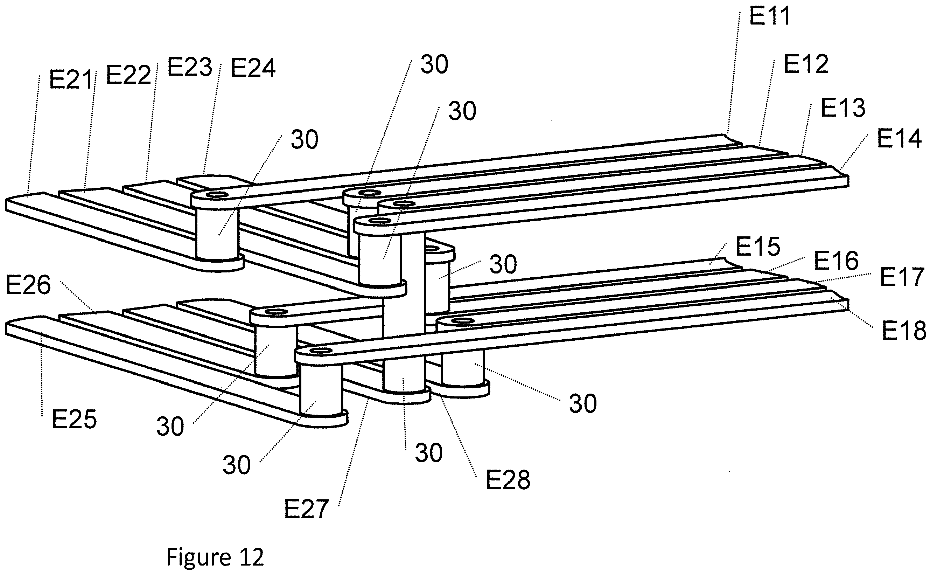

**Figure 12** shows an example of a perturbed connection connecting a first group and a second group on a 4-layer FPC. For convenience, only the elemental conductors *E11, E12, E13, E14, E15, E16, E17, E18, E21, E22, E23, E24, E25, E26, E27, E28* and the vias 30 are shown. The substrate is not drawn.
The first group comprises elemental conductors *E11, E12, E13, E14* on layer one and *E15, E16, E17, E18* on layer three.
The second group comprises the elemental conductors *E21, E22, E23, E24* in layer two and the elemental conductors *E25, E26, E27, E28* in layer four.
*E11* is connected to *E21, E12* to *E23, E13* to *E27, E14* to *E22, E15* to *E26, E16* to *E24, E17* to *E28*, and *E18* to *E25.*
Vias 30 connecting conductors on neighbored layers typically impose no constraints on connection possibilities of other conductors. On the other hand via connections between distant layers can impose limitations. As an example, *E17* could not be connected to *E26* due to the via connection between *E13* and *E27.* Such limitations can be examples of boundary conditions to be considered when designing or optimizing a flexible winding structure.

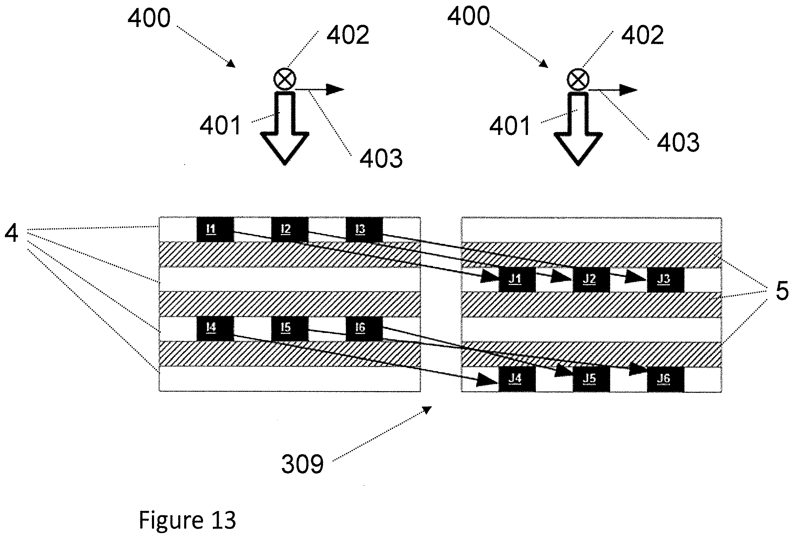

**Figure 13** shows an example not belonging to the invention of an index perturbation 309, where the indexing is according to an orientation. The orthogonal tripod 400 indicates the chosen respective orientation, in particular the choice of a viewing direction orthogonal to the winding structure 401 and the choice of the notion "right" 403. The left cross-section shows a first group, where the indexing is indicated by the notion *"In*", where *n* is the index. The indexing starts in the first layer, because the first group comprises elemental conductors in that layer. The term "first" here refers to the order defined by the choice of a viewing direction orthogonal to the winding structure 401. Within the first layer, the elemental conductors are labelled from left to right, according to choice of the notion "right" 403.
The most left elemental conductor in the first layer is labelled *1* (or *I1*).
The second most left elemental conductor in the first layer is labelled 2 (or *I2*).
The third most left elemental conductor in the first layer is labelled 3 (or *I3*).
The labelling continues in layer three, because the first group does not comprise elemental conductors in layer two. Again "three" and "two" refer to the order defined by the choice of a viewing direction orthogonal to the winding structure 401. The indexing continues with the next natural number, so the most left, "left" here referring to choice of the notion "right" 403, elemental conductor is labelled *4* (or *I*4). The process continues until all elemental conductors of the first group are labelled.
The second group in the right is labelled accordingly. The indexing is indicated by the notion *"Jn",* where *n* is the index
The arrows indicate the group connection. The group connection is an index perturbation 309, because e.g. the elemental conductor *I5* is not connected to the elemental conductor *J5,* but to the elemental conductor *J6*.

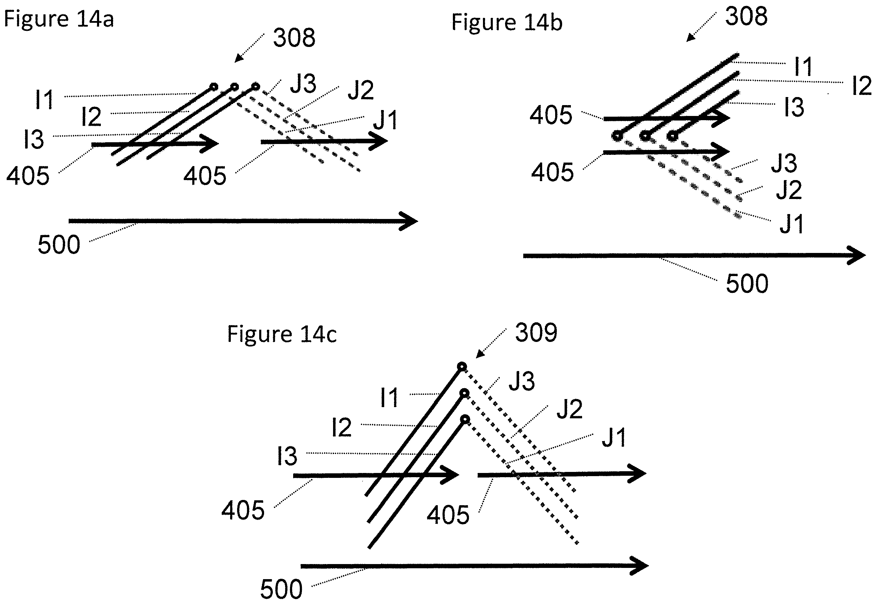

**Figure 14a to 14c** show examples not belonging to the invention of line indexing. The chosen direction of the line of movement is in each case indicated by the arrowhead at one end of a segment of the line of movement 500.
The Figures only show groups having elemental conductors in one layer. Thereby for each depicted group the labelling only occurs in one layer. For a line index, "right" is defined by the chosen direction of the line of movement. The index lines are a local representation of the line of movement. The arrow heads at one end of the index lines 405 indicate the chosen direction of the line of movement. The elemental conductors are labelled according to the position of their intersection point with the index line.

The elemental conductor whose intersection point - among all intersection points of elemental conductors and the line segment in that layer -lies furthest in the direction of the line segment defined by the chosen direction of the line of movement, is the defined to be the *most right.* The elemental conductor whose intersection point - among all intersection points of elemental conductors and the line segment in that layer with the exception of the most "right" elemental conductor - lies furthest in the direction of the line segment defined by the chosen direction of the line of movement, is the defined as the *second most right.* By iteration, the elemental conductors of a group in a layer are ordered from "left" to "right". The indexes of the respective first group are indicated by the notion *"In",* where *n* is the index. The indexes of the respective second group are indicated by the notion *"Jn",* where *n* is the index. The most left is indexed by *1* (or *I1* or *J1*), the second most left is indexed by 2 (or *I2* or *J2*), and so on.

**Figures 14a and 14b** show group connections that are not index perturbations according to the line index 308.

**Figure 14c** shows a group connection that is an index perturbation according to the line index 309 (or - in short - a line index perturbation), e.g. because *I1* is not connected to *J1* but to *J3.*

## Claims

1. A **winding structure** (2) designed to extend along a line of movement in an electrical machine,
wherein the winding structure is realized as a flexible circuit **structure** (3),
a flexible circuit structure being a combination of conductors and an insulating, flexible substrate, where the conductors are located in one or more layers of conductors (4), or - in short - layers,
comprising **elemental conductors** in different layers being electrically connected by **vias** (30, 31, 32, 33, 34),
wherein the elemental conductors are arranged and connected to form at least one **winding phase element** (6),
wherein at least one winding phase element (6) comprises at least two **winding loops** (50),
a winding loop (50) being a series connection of elemental conductors that begins at a location of a first **terminal for powering** (7) the winding phase element (6), runs essentially in a first direction of the line of movement, then runs essentially in a second direction of the line of movement that is essentially opposed to the first direction, and optionally then runs essentially in the first direction, and
∘ either ends at a position whose orthogonal projection onto the line of movement is essentially identical to the orthogonal projection of the first terminal for powering (7) onto the line of movement,
∘ or runs into a second terminal for powering the winding loop,
wherein the winding structure (2) comprises at least two layers of conductors;
wherein the winding structure further comprising at least one **group connection** (300), a group connection (300) being a connection of a first group (200) and a second group (200) by vias, a group (200) being a set of at least two elemental conductors
- that are in the same winding phase element (6),
- that are substantially parallel to each other, and
- that are arranged so that their current flows in the same direction,
where each two elemental conductors connected by the group connection are part of a winding loop (50), the set of these winding loops being called the **winding loops of the group connection;**
**characterized in that**
at least one of the at least one group connection (300) is a **perturbed connection** (307),
a perturbed connection being a group connection that comprises at least one of the following:
∘ a horizontal perturbation, a horizontal perturbation being a connection that connects a set of winding loops of a first layer to a second layer and where the horizontal order of the set of winding loops is neither preserved nor mirrored; or
∘ a vertical perturbation, a vertical perturbation being at least one of the following group connections:
▪ a connection that brings two winding loops from different layers to a common layer, or vice versa; or
▪ a connection that connects a first winding loop that is on top, in the sense of layers, of a second winding loop on a first side of the connection and beneath, in the sense of layers, the second winding loop on a second side of the connection.

2. The winding structure (2) according to claim 1, wherein the at least two winding loops (50) are connected in series.

3. The winding structure (2) according to claim 1 or claim 2, wherein the at least two winding loops (50) are connected in parallel.

4. The winding structure (2) according to one of the claims 1 to 3, wherein the at least one winding phase element (6) comprises at least two **winding bundles** (51) connected in parallel,
a winding bundle (51) being a series connection of elemental conductors that comprises a series connection of one or more winding loops (50) and that connects the two terminals for powering (7) the winding phase element (6).

5. The winding structure (2) according to claim 4, where every winding phase element (6) comprises at least two winding bundles that are connected in parallel.

6. The winding structure (2) according to one of claims 1 to 5, wherein the diameter of the set of vias of the at least one group connection is less than 1/5 of the length of the shortest elemental conductor in either of the groups, preferably less than 1/10 of the length of the shortest elemental conductor in either of the groups, preferably less than 1/100 of the length of the shortest elemental conductor in either of the groups, preferably less than 1/500 of the length of the shortest elemental conductor in either of the groups.

7. The winding structure (2) according to one of claims 1 to 6, wherein at least 10 or 50 or 100 or 500 or 1000 strand connections are perturbed connections,
a strand connection being a group connection connecting two strand groups and a strand group being a group of at least two elemental conductors such that a boundary segment of a current loop is formed either
∘ by the elemental conductors of the strand group; or
∘ by a set that comprises a segment of each elemental conductor of the strand group
wherein boundary segments are defined as being one or more conductor segments forming a current loop, seen from a perspective orthogonal to the layers, that bounds a topological disc, with the current loop, seen from a perspective orthogonal to the layers, having the shape of a topological circle.

8. A method for designing a flexible winding structure according to one of claims 1 to 7, wherein perturbed connections are chosen to reduce a difference in induced voltages in corresponding parallel connected winding bundles.

9. The method of claim 8, wherein the perturbed connections are determined by using a data processing unit and/or an optimization procedure.

10. The method of one of claims 8 or 9, comprising the following steps:
• choosing an initial pattern for a flexible winding structure;
• defining a target function, whose value quantifies the amount of losses caused by circular currents in corresponding parallel connected winding bundles and whose variables comprise possible perturbed connections or index perturbations of the connections determined by the initial pattern for the flexible winding structure;
• determining a, possibly empty, set of boundary conditions;
• reducing, preferably at least approximately minimizing, the target function with respect to the set of boundary conditions, preferably using a data processing unit and/or an optimization algorithm;
• creating a modified pattern for the flexible winding structure based on the result of the step of reducing, preferably at least approximately minimizing, the target function with respect to the set of boundary conditions.

## Patentansprüche

1. **Wicklungsstruktur** (2), die dazu ausgelegt ist, sich entlang einer Bewegungslinie in einer elektrischen Maschine zu erstrecken,
wobei die Wicklungsstruktur als eine flexible **Schaltungsstruktur** (3) realisiert ist, wobei eine flexible Schaltungsstruktur eine Kombination von Leitern und einem isolierenden, flexiblen Substrat ist, wobei die Leiter in einer oder mehreren Lagen von Leitern (4) oder - kurz gesagt - in Lagen angeordnet sind,
umfassend **Elementarleiter** in verschiedenen Lagen, die durch **Durchkontaktierungen** (30, 31, 32, 33, 34) elektrisch verbunden sind,
wobei die Elementarleiter so angeordnet und verbunden sind, dass sie mindestens ein **Wicklungsphasenelement** (6) bilden,
wobei mindestens ein Wicklungsphasenelement (6) mindestens zwei **Wicklungsschleifen** (50) umfasst,
eine Wicklungsschleife (50), die eine Reihenschaltung von Elementarleitern ist, die an einer Stelle einer ersten **Klemme zur Stromversorgung** (7) des Wicklungsphasenelements (6) beginnt, im Wesentlichen in eine erste Richtung der Bewegungslinie verläuft, dann im Wesentlichen in eine zweite Richtung der Bewegungslinie verläuft, die der ersten Richtung im Wesentlichen entgegengesetzt ist, und gegebenenfalls dann im Wesentlichen in die erste Richtung verläuft, und
∘ entweder an einer Stelle endet, deren orthogonale Projektion auf die Bewegungslinie im Wesentlichen identisch mit der orthogonalen Projektion der ersten Klemme zur Stromversorgung (7) auf die Bewegungslinie ist,
∘ oder in eine zweite Klemme zur Stromversorgung der Wicklungsschleife verläuft,
wobei die Wicklungsstruktur (2) mindestens zwei Lagen von Leitern umfasst;
wobei die Wicklungsstruktur ferner mindestens eine **Gruppenverbindung** (300) umfasst, wobei eine Gruppenverbindung (300) eine Verbindung einer ersten Gruppe (200) und einer zweiten Gruppe (200) durch Durchkontaktierungen ist, wobei eine Gruppe (200) eine Menge von mindestens zwei Elementarleitern ist
- die sich im gleichen Wicklungsphasenelement befinden (6),
- die im Wesentlichen parallel zueinander liegen, und
- die so angeordnet sind, dass ihr Strom in die gleiche Richtung fließt,
wobei jeweils zwei durch den Gruppenanschluss verbundene Elementarleiter Teil einer Wicklungsschleife (50) sind, wobei die Menge dieser Wicklungsschleifen als die **Wicklungsschleifen der Gruppenverbindung** bezeichnet wird;
**dadurch gekennzeichnet, dass**
mindestens eine der mindestens einen Gruppenverbindung (300) eine **perturbierte Verbindung** (307) ist,
wobei eine perturbierte Verbindung eine Gruppenverbindung ist, die mindestens eines des Folgenden umfasst:
∘ eine horizontale Perturbation, wobei eine horizontale Perturbation eine Verbindung ist, die eine Menge von Wicklungsschleifen einer ersten Lage mit einer zweiten Lage verbindet und bei der die horizontale Reihenfolge der Menge von Wicklungsschleifen weder beibehalten noch gespiegelt wird; oder
∘ eine vertikale Perturbation, wobei eine vertikale Perturbation mindestens eine der folgenden Gruppenverbindungen ist:
• eine Verbindung, die zwei Wicklungsschleifen aus verschiedenen Lagen auf eine gemeinsame Lage bringt oder umgekehrt; oder
• eine Verbindung, die eine erste Wicklungsschleife verbindet, die oben, im Sinne von Lagen, auf einer ersten Seite der Verbindung und unter, im Sinne von Lagen, der zweiten Wicklungsschleife auf einer zweiten Seite der Verbindung liegt.

2. Wicklungsstruktur (2) nach Anspruch 1, wobei die mindestens zwei Wicklungsschleifen (50) in Reihe geschaltet sind.

3. Wicklungsstruktur (2) nach Anspruch 1 oder Anspruch 2, wobei die mindestens zwei Wicklungsschleifen (50) parallel geschaltet sind.

4. Wicklungsstruktur (2) nach einem der Ansprüche 1 bis 3, wobei das mindestens eine Wicklungsphasenelement (6) mindestens zwei parallel geschaltete **Wicklungsbündel** (51) umfasst,
wobei ein Wicklungsbündel (51) eine Reihenschaltung von Elementarleitern ist, die eine Reihenschaltung von einer oder mehreren Wicklungsschleifen (50) umfasst und die die beiden Klemmen zur Stromversorgung (7) des Wicklungsphasenelements (6) verbindet.

5. Wicklungsstruktur (2) nach Anspruch 4, wobei jedes Wicklungsphasenelement (6) mindestens zwei parallel geschaltete Wicklungsbündel umfasst.

6. Wicklungsstruktur (2) nach einem der Ansprüche 1 bis 5, wobei der Durchmesser der Menge von Durchkontaktierungen der mindestens einen Gruppenverbindung weniger als 1/5 der Länge des kürzesten Elementarleiters in jeder der Gruppen, vorzugsweise weniger als 1/10 der Länge des kürzesten Elementarleiters in jeder der Gruppen, vorzugsweise weniger als 1/100 der Länge des kürzesten Elementarleiters in jeder der Gruppen, vorzugsweise weniger als 1/500 der Länge des kürzesten Elementarleiters in jeder der Gruppen, beträgt.

7. Wicklungsstruktur (2) nach einem der Ansprüche 1 bis 6, wobei mindestens 10 oder 50 oder 100 oder 500 oder 1000 Litzenverbindungen perturbierte Verbindungen sind, wobei eine Litzenverbindung eine Gruppenverbindung ist, die zwei Litzengruppen verbindet, und eine Litzengruppe eine Gruppe von mindestens zwei Elementarleitern ist, sodass ein Grenzsegment einer Stromschleife gebildet wird entweder
∘ durch die Elementarleiter der Litzengruppe; oder
∘ durch eine Menge, die ein Segment jedes Elementarleiters der Litzengruppe umfasst
wobei Grenzsegmente als ein oder mehrere Leitersegmente definiert sind, die, aus einer zu den Lagen orthogonalen Perspektive gesehen, eine Stromschleife bilden, die eine topologische Scheibe begrenzt, wobei die Stromschleife, aus einer zu den Lagen orthogonalen Perspektive gesehen, die Form eines topologischen Kreises aufweist.

8. Verfahren zum Konstruieren einer flexiblen Wicklungsstruktur nach einem der Ansprüche 1 bis 7, wobei perturbierte Verbindungen gewählt werden, um eine Differenz der induzierten Spannungen in entsprechenden parallel geschalteten Wicklungsbündeln zu reduzieren.

9. Verfahren nach Anspruch 8, wobei die perturbierten Verbindungen unter Verwendung einer Datenverarbeitungseinheit und/oder eines Optimierungsverfahrens bestimmt werden.

10. Verfahren nach einem der Ansprüche 8 oder 9, das die folgenden Schritte umfasst:
• Wählen eines Anfangsmusters für eine flexible Wicklungsstruktur;
• Definieren einer Zielfunktion, deren Wert die Höhe der Verluste quantifiziert, die durch Kreisströme in entsprechenden parallel geschalteten Wicklungsbündeln verursacht werden, und deren Variablen mögliche perturbierte Verbindungen oder Indexperturbationen der Verbindungen umfassen, die durch das Anfangsmuster für die flexible Wicklungsstruktur bestimmt werden;
• Bestimmen einer möglicherweise leeren Menge von Randbedingungen;
• Reduzieren, vorzugsweise zumindest näherungsweises Minimieren, der Zielfunktion in Bezug zur Menge der Randbedingungen, vorzugsweise unter Verwendung einer Datenverarbeitungseinheit und/oder eines Optimierungsalgorithmus;
• Erstellen eines modifizierten Musters für die flexible Wicklungsstruktur basierend auf dem Ergebnis des Schrittes des Reduzierens, vorzugsweise zumindest des näherungsweisen Minimierens, der Zielfunktion in Bezug auf die Menge von Randbedingungen.

## Revendications

1. Structure de bobinage (2) conçue pour s'étendre le long d'une ligne de déplacement dans une machine électrique,
la structure de bobinage étant réalisée sous la forme d'une structure (3) en circuit flexible,
une structure en circuit flexible étant une combinaison de conducteurs et d'un support isolant flexible, les conducteurs étant situés en une ou plusieurs couches de conducteurs (4) ou, en abrégé, en couches,
comprenant des conducteurs élémentaires disposés en différentes couches raccordées électriquement par des passages (30, 31, 32, 33, 34),
les conducteurs élémentaires étant agencés et raccordés de manière à former au moins un élément (6) de phase de bobinage,
au moins un élément (6) de phase de bobinage comprenant au moins deux boucles de bobinage (50),
une boucle de bobinage (50) étant une connexion en série de conducteurs élémentaires qui commence à l'emplacement d'une première borne d'alimentation (7) de l'élément (6) de phase de bobinage, qui s'étend essentiellement dans une première direction de la ligne de déplacement et ensuite essentiellement dans une deuxième direction de la ligne de déplacement, essentiellement opposée à la première direction, pour facultativement ensuite s'étendre essentiellement dans la première direction et
- se termine en une position dont la projection orthogonale sur la ligne de déplacement est essentiellement identique à la projection orthogonale de la première borne d'alimentation (7) sur la ligne de déplacement
- ou s'étend jusque dans une deuxième borne d'alimentation de la boucle de bobinage,
la structure de bobinage (2) comprenant au moins deux couches de conducteurs,
la structure de bobinage (2) comprenant en outre au moins une connexion de groupes (300), une connexion de groupes (300) étant une connexion d'un premier groupe (200) et d'un deuxième groupe (200) par l'intermédiaire de passages, un groupe (200) étant un jeu d'au moins deux conducteurs élémentaires
- qui sont situés dans le même élément (6) de phase de bobinage,
- qui sont essentiellement parallèles l'un à l'autre et
- qui sont agencés de telle sorte que leur courant s'écoule dans la même direction,
chacun des deux conducteurs élémentaires raccordés par la connexion de groupes faisant partie d'une boucle de bobinage (50), le jeu de ces boucles de bobinage étant appelé boucles de bobinage de la connexion de groupes,
**caractérisée en ce que**
au moins l'une des différentes connexion de groupes (300) est une connexion perturbée (307), une connexion perturbée étant une connexion de groupes qui comprend au moins l'une des caractéristiques suivantes :
- une perturbation horizontale, une perturbation horizontale étant une connexion qui raccorde un jeu de boucles de bobinage d'une première couche à une deuxième couche et où l'ordre horizontal du jeu de boucles de bobinage n'est ni conservé ni inversé ou
- une perturbation verticale, une perturbation verticale étant au moins l'une des connexions de groupes suivantes :
- une connexion qui amène deux boucles de bobinage de couches différentes vers une couche commune ou inversement, ou
- une connexion qui relie une première boucle de bobinage, située au sommet dans le sens des couches, d'une deuxième boucle de bobinage située sur un premier côté de la connexion et en dessous, dans le sens des couches, de la deuxième boucle de bobinage située sur un deuxième côté de la connexion.

2. Structure de bobinage (2) selon la revendication 1, dans laquelle les deux ou plusieurs boucles de bobinage (50) sont raccordées en série.

3. Structure de bobinage (2) selon la revendication 1 ou la revendication 2, dans laquelle les deux ou plusieurs boucles de bobinage (50) sont raccordées en parallèle.

4. Structure de bobinage (2) selon l'une des revendications 1 à 3, dans laquelle le ou les éléments (6) de phase de bobinage comprennent au moins deux faisceaux de bobinage (51) raccordés en parallèle,
un faisceau de bobinage (51) étant une connexion en série de conducteurs élémentaires qui comprend une connexion en série d'une ou plusieurs boucles de bobinage (50) qui relient les deux bornes d'alimentation (7) de l'élément (6) de phase de bobinage.

5. Structure de bobinage (2) selon la revendication 4, dans laquelle chaque élément (6) de phase de bobinage comprend au moins deux faisceaux de bobinage raccordés en parallèle.

6. Structure de bobinage (2) selon l'une des revendications 1 à 5, dans laquelle le diamètre du jeu de passages de la ou des connexions de groupes représente moins de 1/5 de la longueur du conducteur élémentaire le plus court d'un quelconque des groupes, de préférence moins de 1/10 de la longueur du conducteur élémentaire le plus court d'un quelconque des groupes, de préférence moins de 1/100 de la longueur du conducteur élémentaire le plus court d'un quelconque des groupes et de préférence moins de 1/500 de la longueur du conducteur élémentaire le plus court d'un quelconque des groupes.

7. Structure de bobinage (2) selon l'une des revendications 1 à 6, dans laquelle au moins 10, 50, 100, 500 ou 1000 connexions de brins sont des connexions perturbées,
une connexion de brins étant une connexion de groupes qui raccorde deux groupes de brins et un groupe de brins étant un groupe d'au moins deux conducteurs élémentaires dans lequel un segment de frontière d'une boucle de courant est formé
- par les conducteurs élémentaires du groupe de brins ou
- par un ensemble qui comprend un segment de chaque conducteur élémentaire du groupe de brins,
des segments de frontière étant définis comme étant un ou plusieurs segments de conducteurs formant une boucle de courant, vue dans une perspective perpendiculaire aux couches, qui délimite un disque topologique, la boucle de courant, vue dans une perspective orthogonale aux couches, présentant la forme d'un cercle topologique.

8. Procédé de conception d'une structure flexible de bobinage selon l'une des revendications 1 à 7, dans lequel des connexions perturbées sont choisies de manière à réduire la différence entre les tensions induites dans des faisceaux de bobinage connectés en parallèle correspondants.

9. Procédé selon la revendication 8, dans lequel les connexions perturbées sont déterminées en utilisant une unité de traitement de données et/ou une procédure d'optimisation.

10. Procédé selon l'une des revendications 8 ou 9, comprenant les étapes suivantes :
- sélection d'un motif initial de structure de bobinage flexible,
- définition d'une fonction cible dont la valeur quantifie le niveau de perte provoqué par les courants circulaires dans des faisceaux de bobinage connectés en parallèle correspondants et dont les variables comprennent des connexions perturbées possibles ou des perturbations d'indice des connexions déterminées par le motif initial de la structure de bobinage flexible,
- détermination d'un ensemble, éventuellement vide, de conditions aux frontières,
- réduction, de préférence minimisation au moins approximative de la fonction cible par rapport à l'ensemble de conditions aux limites, de préférence en utilisant une unité de traitement de données et/ou un algorithme d'optimisation et
- création d'un motif modifié de la structure de bobinage flexible sur la base du résultat de l'étape de réduction, de préférence de minimisation au moins approximative, de la fonction cible par rapport à l'ensemble de conditions aux limites.
